# EUROPEAN PATENT APPLICATION

(11) **EP 2 711 975 A1**
(43) Date of publication of application: **26.03.2014**
(21) Application number: 12784883.6
(22) Date of filing: 10.05.2012
(51) Int. Cl.: H01L 21/338, H01L 29/778, H01L 29/812

(54) **SEMICONDUCTOR ELEMENT AND METHOD FOR PRODUCING SAME**

(30) Priority: 17.05.2011 JP 2011110673
(71) Applicant: Advanced Power Device Research Association, Yokohama-shi, Kanagawa 220-0073 (JP)
(72) Inventor: KOKAWA, Takuya, Yokohama-shi, Kanagawa 220-0073 (JP); KATOU, Sadahiro, Yokohama-shi, Kanagawa 220-0073 (JP); IWAMI, Masayuki, Yokohama-shi, Kanagawa 220-0073 (JP); UTSUMI, Makoto, Yokohama-shi, Kanagawa 220-0073 (JP); UMENO, Kazuyuki, Yokohama-shi, Kanagawa 220-0073 (JP)
(74) Representative: Horn Kleimann Waitzhofer
(86) International application number: PCT/JP2012/003077
(87) International publication number: WO 2012/157229

(57) **Abstract**

Provided are a nitride-based semiconductor element with reduced leak current, and a manufacturing method thereof. The semiconductor element comprises a substrate; a buffer region that is formed above the substrate; an active layer that is formed on the buffer region; and at least two electrodes that are formed on the active layer. The buffer region includes a plurality of semiconductor layers having different lattice constants, and there is a substantially constant electrostatic capacitance between a bottom surface of the substrate and a top surface of the buffer region when a potential that is less than a potential of the bottom surface of the substrate is applied to the top surface of the buffer region and a voltage between the bottom surface of the substrate and the top surface of the buffer region is changed within a range corresponding to thickness of the buffer region.

## Description

### BACKGROUND

### 1. TECHNICAL FIELD

The present invention relates to a semiconductor element and a method of manufacturing a semiconductor element. In particular, the present invention relates to a semiconductor element with a reduced leak current, and to a manufacturing method of this semiconductor element.

### 2. RELATED ART

Conventionally, a semiconductor element is known that is includes a buffer region, which is formed by repeatedly layering AlN layers and GaN layers on a silicon substrate, and a nitride-based semiconductor formed on the buffer region. This buffer region functions to lessen the lattice constant difference or thermal expansion coefficient difference between the silicon substrate and the nitride-based semiconductor, to reduce dislocation and the occurrence of cracking. However, two-dimensional electron gas is generated at the hetero-interfaces between the AlN layers and the GaN layers, and therefore a leak current flows through the semiconductor element. In order to reduce this leak current, a method has been proposed to provide AlGaN layers between the AlN layers and the GaN layers, as shown in Patent Document 1, for example.
Patent Document 1: Japanese Patent No. 4525894

However, with this conventional method, the carriers between the AlN layers and the GaN layers cannot be sufficiently reduced. As a result, the leak current of the semiconductor element cannot be sufficiently restricted.

### SUMMARY

According to a first aspect of the present invention, provided is a semiconductor element comprising a substrate; a buffer region that is formed above the substrate; an active layer that is formed on the buffer region; and at least two electrodes that are formed on the active layer. The buffer region includes a plurality of semiconductor layers having different lattice constants, and there is a substantially constant electrostatic capacitance between a bottom surface of the substrate and a top surface of the buffer region when a potential that is less than a potential of the bottom surface of the substrate is applied to the top surface of the buffer region and a voltage between the bottom surface of the substrate and the top surface of the buffer region is changed within a range corresponding to thickness of the buffer region. If a potential is to be applied to the surface of the buffer region, the electrodes may be formed on the surface of the buffer region, or the electrodes may be formed on a surface of a semiconductor layer formed on the surface of the buffer region. If the topmost layer of the buffer region is a GaN layer, the electrodes may be formed on the surface of the buffer region. If the topmost layer of the buffer region is not a GaN layer, a GaN layer may be formed on the surface of the buffer region and the electrodes may be formed on the surface of this GaN layer. By applying voltage to these electrodes, a potential can be applied to the surface of the buffer region.

According to a second aspect of the present invention, provided is a semiconductor element manufacturing method comprising preparing a substrate; forming a buffer region above the substrate; forming an active layer on the buffer region; and forming at least two electrodes on the active layer. The forming the buffer region includes performing, at least once, a cycle that includes forming a first semiconductor layer with a first lattice constant, forming a second semiconductor layer with a second lattice constant, and forming a third semiconductor layer with a third lattice constant that is different from the first lattice constant, in the stated order, the second lattice constant is between the first lattice constant and the third lattice constant, and the forming the second semiconductor layer includes doping with impurities.

The summary clause does not necessarily describe all necessary features of the embodiments of the present invention. The present invention may also be a subcombination of the features described above.

### BRIEF DESCRIPTION OF THE DRAWINGS

Fig. 1 is a cross-sectional view of an epitaxially layered body manufactured according to the conventional method.
Fig. 2 is a graph showing the voltage-electrostatic capacitance characteristic of the epitaxially layered body shown in Fig. 1.
Fig. 3 shows the ratio of change in the Al composition of four AlₓGa₁₋ₓN (0 < x ≤ 1) layers used in the simulation.
Fig. 4 shows simulation results for the carrier concentration distribution of the AlₓGa₁₋ₓN (0 < x ≤ 1) layers of examples A to D.
Fig. 5 shows calculation results obtained by integrating the carrier concentration in an integration range from the topmost GaN layer to the bottommost GaN layer in the GaN/AlN/AlGaN/GaN structure.
Fig. 6 shows simulation results for the carrier concentration peak values in each of patterns A to D.
Fig. 7 is a cross-sectional view of a semiconductor element according to a first embodiment of the present invention.
Fig. 8 shows change in the Al composition of the buffer region in the semiconductor element shown in Fig. 7, in a thickness direction.
Fig. 9 shows the voltage-electrostatic capacitance characteristic of the epitaxially layered body obtained by doping the AlGaN layer shown in Fig. 1 with carbon C.
Fig. 10 shows another exemplary voltage-electrostatic capacitance characteristic of the epitaxially layered body obtained by doping the AlGaN layer shown in Fig. 1 with carbon C.
Fig. 11 schematically shows an example of implanting C in the surface of the GaN layer on the AlN layer side in a composite layer formed by sequentially depositing GaN layers and AlN layers.
Fig. 12 schematically shows an example of implanting C in the AlGaN layers of a composite layer formed by sequentially depositing GaN layers, AlGaN layers, and AlN layers.
Fig. 13 shows another example of A1 composition ratio change in the second semiconductor layer of the semiconductor element shown in Fig. 1.
Fig. 14 shows another example of A1 composition ratio change in the second semiconductor layer of the semiconductor element shown in Fig. 1.
Fig. 15 shows another example of A1 composition ratio change in the second semiconductor layer of the semiconductor element shown in Fig. 1.
Fig. 16 shows another example of A1 composition ratio change in the second semiconductor layer of the semiconductor element shown in Fig. 1.
Fig. 17 shows another example of A1 composition ratio change in the second semiconductor layer of the semiconductor element shown in Fig. 1.
Fig. 18 shows another example of Al composition ratio change in the second semiconductor layer of the semiconductor element shown in Fig. 1.
Fig. 19 shows another example of Al composition ratio change in the second semiconductor layer of the semiconductor element shown in Fig. 1.
Fig. 20 is a cross-sectional view of a semiconductor element according to a second embodiment of the present invention.
Fig. 21 shows change in the Al composition of the buffer region in the semiconductor element shown in Fig. 20, in a thickness direction.
Fig. 22 shows another example of change in the Al composition of the second semiconductor layer and the fourth semiconductor layer in the semiconductor element shown in Fig. 20.
Fig. 23 shows another example of change in the Al composition of the second semiconductor layer and the fourth semiconductor layer in the semiconductor element shown in Fig. 20.
Fig. 24 shows another example of change in the Al composition of the second semiconductor layer and the fourth semiconductor layer in the semiconductor element shown in Fig. 20.
Fig. 25 shows another example of change in the Al composition of the second semiconductor layer and the fourth semiconductor layer in the semiconductor element shown in Fig. 20.
Fig. 26 shows another example of change in the Al composition of the second semiconductor layer and the fourth semiconductor layer in the semiconductor element shown in Fig. 20.
Fig. 27 shows another example of change in the Al composition of the second semiconductor layer and the fourth semiconductor layer in the semiconductor element shown in Fig. 20.
Fig. 28 shows another example of change in the Al composition of the second semiconductor layer and the fourth semiconductor layer in the semiconductor element shown in Fig. 20.
Fig. 29 shows an example of change in the Al composition in a case where an extremely thin semiconductor layer is formed at an interface with a layer adjacent to the second semiconductor layer or the fourth semiconductor layer in the semiconductor element shown in Fig. 20.
Fig. 30 shows another example of change in the Al composition in a case where an extremely thin semiconductor layer is formed at an interface with a layer adjacent to the second semiconductor layer or the fourth semiconductor layer in the semiconductor element shown in Fig. 20.
Fig. 31 shows another example of change in the Al composition in a case where an extremely thin semiconductor layer is formed at an interface with a layer adjacent to the second semiconductor layer or the fourth semiconductor layer in the semiconductor element shown in Fig. 20.
Fig. 32 shows an example in which the thicknesses of the second semiconductor layer and the fourth semiconductor layer in each composite layer in the buffer region of the semiconductor element shown in Fig. 20 are changed.
Fig. 33 shows an example in which the thicknesses of the second semiconductor layer and the fourth semiconductor layer in each composite layer of the semiconductor element shown in Fig. 20 are changed.
Fig. 34 shows a relationship between the number of composite layers and the leak current and warpage amount in examples where the total thickness of the semiconductor element shown in Fig. 20 remains constant, the total number of composite layers is twelve, and only the number of composite layers in the buffer region is changed.
Fig. 35 shows a relationship between the thicknesses of the second semiconductor layers and fourth semiconductor layers in the buffer region of the semiconductor element shown in Fig. 20 and the leak current.
Fig. 36 shows a relationship between the C doping concentrations in the second semiconductor layers and fourth semiconductor layers of the semiconductor element shown in Fig. 20 and the leak current.
Fig. 37 shows a relationship between the leak current and the impurity doping concentration in the second semiconductor layers and the fourth semiconductor layers of the semiconductor element shown in Fig. 20, when the impurity used is fluorine, chlorine, magnesium, iron, oxygen, or hydrogen, instead of C.
Fig. 38 shows a relationship between the leak current and the Al composition ratio in the third semiconductor layer, when the entire third semiconductor layer of the semiconductor element shown in Fig. 20 is replaced by AlGaN.
Fig. 39 shows a relationship between the leak current and the C doping concentration in the third semiconductor layer of the semiconductor element shown in Fig. 20.
Fig. 40 shows a relationship between the leak current and the C doping concentration in the first semiconductor layer of the semiconductor element shown in Fig. 20.
Fig. 41 shows examples 1 to 5 having different numbers of composite layers and different thicknesses of the first semiconductor layers in the buffer region of the semiconductor element shown in Fig. 20.
Fig. 42 shows measurement results for the leak current and warpage amount of the examples 1 to 5 shown in Fig. 41.
Fig. 43 shows a layered body used for calculating the carrier state density distribution.
Fig. 44 shows the carrier state density distribution of the GaN layer above the AlN layer in the layered body shown in Fig. 43.
Fig. 45 shows the carrier state density distribution of the GaN layer below the AlN layer in the layered body shown in Fig. 43.
Fig. 46 shows an example in which the surface of the GaN layer below the AlN layer is doped with acceptor-type impurities.
Fig. 47 shows the carrier state density distribution of the GaN layer above the AlN layer in the example shown in Fig. 46.
Fig. 48 shows the carrier state density distribution of the GaN layer below the AlN layer in the example shown in Fig. 46.
Fig. 49 shows an example in which the surface of the GaN layer above the AlN layer is doped with donor-type impurities.
Fig. 50 shows the carrier state density distribution of the GaN layer above the AlN layer in the example shown in Fig. 49.
Fig. 51 shows the carrier state density distribution of the GaN layer below the AlN layer in the example shown in Fig. 49.

### DESCRIPTION OF EXEMPLARY EMBODIMENTS

Hereinafter, some embodiments of the present invention will be described. The embodiments do not limit the invention according to the claims, and all the combinations of the features described in the embodiments are not necessarily essential to means provided by aspects of the invention.

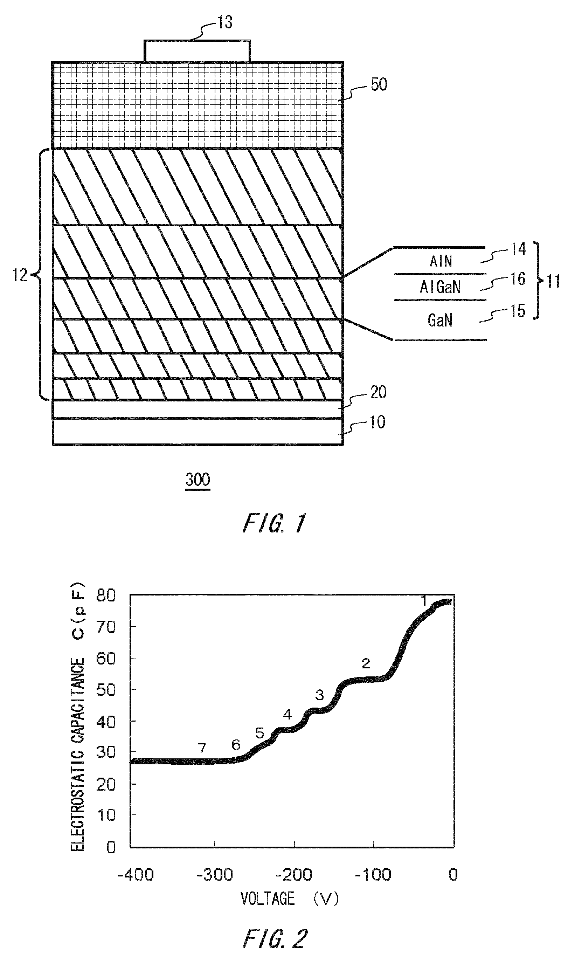

Fig. 1 is a cross-sectional view of an epitaxially layered body 300, which is a comparative example. The epitaxially layered body 300 includes a substrate 10, an intermediate layer 20, a buffer layer 12, and an electron transit layer 50. The substrate 10 includes monocrystalline silicon and has the (111) surface as the primary surface. The primary surface refers to the surface on which the buffer layer 12 and the like are to be layered.

The intermediate layer 20 is layered on the primary surface of the substrate 10. The intermediate layer 20 functions as an alloy preventing layer that prevents a chemical reaction between the substrate 10 and the buffer layer 12. The intermediate layer 20 may be undoped AlN, for example.

The buffer layer 12 includes six composite layers 11 that are formed on the intermediate layer 20 in a manner such that each of the six layers is progressively thicker. Each composite layer 11 includes a GaN layer 15 formed on the substrate 10 side, an AlGaN layer 16 formed on the GaN layer 15, and an AlN layer 14 formed on the AlGaN layer 16. The AlGaN layer 16 may have an Al composition ratio that gradually decreases in a direction from the region contacting the AlN layer 14 to a region contacting the GaN layer 15. The AlGaN layer 16 is inserted to reduce the two-dimensional electron gas generated at the interface between the AlN layer 14 and the GaN layer 15.

The electron transit layer 50 is formed of GaN on the buffer layer 12. In this way, a seven-layer structure of GaN/AlN pairs is formed by the intermediate layer 20, the buffer layers 12, and the electron transit layer 50. Specifically, a first pair is formed by the electron transit layer 50 and the AlN layer 14 of the topmost composite layer 11, and a seventh pair is formed by the intermediate layer 20 and the GaN layer 15 of the bottommost composite layer 11.

In the conventional epitaxially layered body 300 shown in Fig. 1, in order to measure the voltage-electrostatic capacitance characteristic between the top surface of the buffer layer 12 and the bottom surface of the substrate 10, a Schottky electrode 13 is formed on the top surface of the electron transit layer 50. As described above, when the topmost layer of the buffer layer 12 is a GaN layer 15, the Schottky electrode 13 may be formed on this GaN layer 15.

The Schottky electrode 13 includes a layered structure of Ni/Au/Ti, for example. Through experimentation, the voltage-electrostatic capacitance characteristic was measured by setting a ground potential for the bottom surface of the substrate 10 and applying a negative voltage to the Schottky electrode 13. An LCR meter was used for the measurement of the voltage-electrostatic capacitance characteristic. Furthermore, the frequency of the applied voltage was 100 kHz.

Fig. 2 is a graph showing the voltage-electrostatic capacitance characteristic of the epitaxially layered body 300. As shown in Fig. 2, as the voltage drops from 0 V to more negative values, the electrostatic capacitance decreases in a stepped manner, and no change in the electrostatic capacitance was observed for voltages of -400 V and below. The intervals between the steps 1 to 7 of the electrostatic capacitance shown in the graph correspond to the thicknesses of the seven GaN/AlN pair layers arranged in a direction from the Schottky electrode 13 side to the substrate 10 side, and therefore this graph suggests that there is an equipotential surface at the interface between each pair, i.e. at the AlGaN layer 16 in each composite layer 11. These equipotential surfaces are believed to exist because of two-dimensional electron gas or carriers remaining in the composite layers 11.

Usually, when the absolute value of the voltage applied to the buffer layer 12 is increased, the depletion layer expands in a direction from the Schottky electrode 13 to the substrate 10 and the electrostatic capacitance gradually changes. However, according to the characteristic shown in Fig. 2, the electrostatic capacitance does not change at first, even though the voltage is gradually dropping from 0 V to become more negative. This is believed to be because the depletion layer does not expand until the applied voltage is capable of eliminating the two-dimensional electron gas or the carrier in the topmost first composite layer 11-1.

When the two-dimensional electron gas or the carrier in the first composite layer 11-1 is eliminated, the depletion layer expands toward the substrate 10 along with the increase in the absolute value of the voltage, and the electrostatic capacitance decreased. When the depletion layer reaches the next second composite layer 11-2, the electrostatic capacitance does not change until a voltage is reached that completely eliminates the two-dimensional electron gas or the carriers, in the same manner as in the first composite layer 11-1. The layers from the third composite layer 11-3 exhibit the same behavior.

The steps 1 to 7 appearing in the graph of Fig. 2 can be seen as the capacitor capacitance of each GaN/AlN pair formed by the intermediate layer 20, the composite layers 11, and the electron transit layer 50. In other words, the graph suggests that the interface between each pair described above, i.e. the interface at each AlGaN layer 16, is an equipotential surface, and that charge exists at these interfaces. Specifically, it is understood that in a conventional buffer layer structure where composite layers of AlN/AlGaN/GaN are repeated, the carrier amount cannot be sufficiently reduced.

Next, the carrier density distribution in the composite layers 11 shown in Fig. 1 was calculated through a simulation. The simulation was performed for four consecutive composite layers 11 that each have an AlGaN layer 16 with a different thickness.

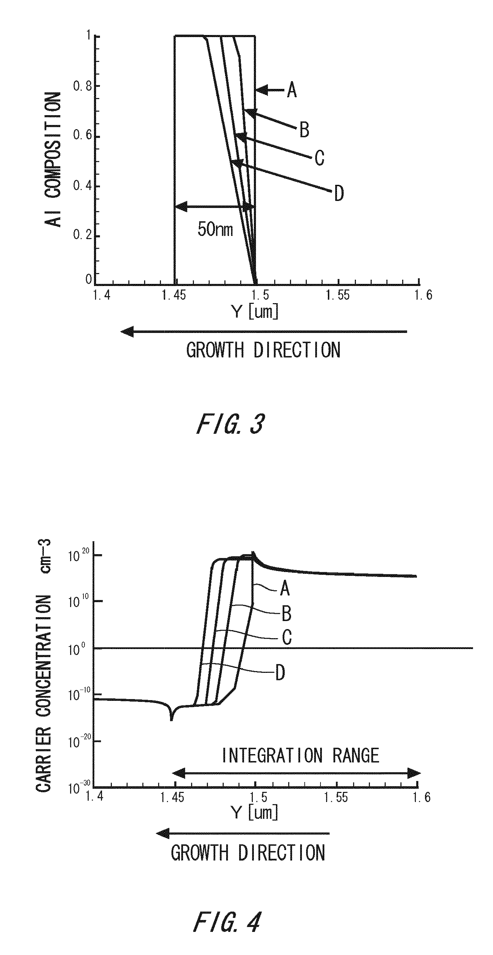

Fig. 3 shows the ratio of change in the Al composition of the four composite layers 11 used in the simulation. In Fig. 3, the horizontal axis indicates the position Y in the growth direction of the composite layer 11. The Al concentration of each AlGaN layer 16 was changed linearly from 0 to 1. The total thickness of each pair of an AlGaN layer 16 and an AlN layer 14 was 50 nm.

Pattern A shows results obtained when the AlGaN layer had a thickness of 0 nm, pattern B shows results obtained when the AlGaN layer had a thickness of 20 nm, pattern C shows results obtained when the AlGaN layer had a thickness of 30 nm, and pattern D shows results obtained when the AlGaN layer had a thickness of 40 nm. As the thickness increases, the gradient of the change in the Al composition ratio becomes greater.

Fig. 4 shows simulation results for the carrier concentration distribution of the AlGaN layers having the patterns A to D. The horizontal axis represents the position Y in the growth direction of the composite layer 11, and the vertical axis represents the carrier concentration.

Pattern A has a weak upward peak near Y = 1.5 µm. As shown in Fig. 3, in pattern A, an AlN layer 14 and a GaN layer 15 contact each other near Y = 1.5 µm. Therefore, it is believed that high-density two-dimensional electron gas is generated near Y = 1.5 µm. Pattern A has a weak downward peak near Y = 1.45 µm. As shown in Fig. 3, in pattern A, a GaN layer 15 and an AlN layer 14 contact each other near Y = 1.45 µm. Therefore, it is believed that high-density two-dimensional hole gas is generated near Y = 1.45 µm.

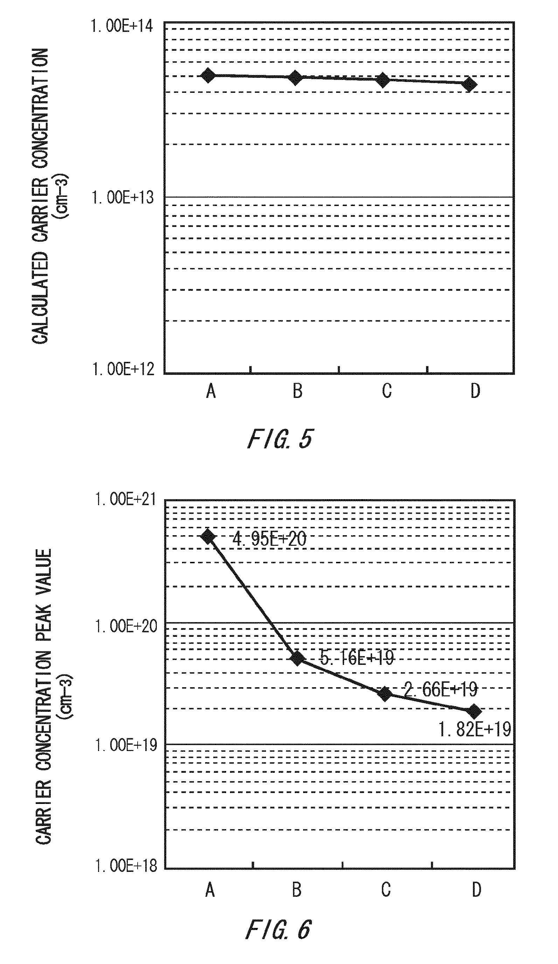

Fig. 5 shows calculation results obtained by integrating the carrier concentration in the integration range shown in Fig. 4. In patterns A to D, no significant change was seen in the calculated carrier concentration. In other words, it is understood that the patterns A to D do not exhibit large changes in the total carrier amount.

Fig. 6 shows simulation results for the carrier concentration peak values in each of patterns A to D. Pattern A has the highest peak value of 4.95E+20, and patterns B to D all have peak values that are approximately 10% or less of the peak value of pattern A. Based on these results, it is understood that the carriers are scattered by inserting the AlGaN layer between the GaN layer and the AlN layer. In other words, in the structure shown in Fig. 1, the maximum carrier density can be decreased, but the total carrier amount does not change from that of pattern A, in which high-density two-dimensional electron gas is generated.

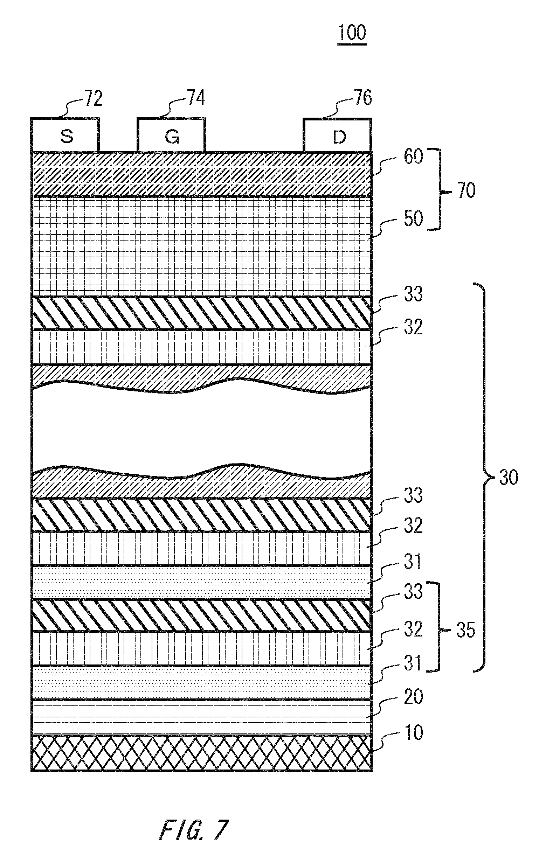

Fig. 7 is a cross-sectional view of a semiconductor element 100 according to a first embodiment of the present invention. The semiconductor element 100 is described using an HEMT as an example, but the semiconductor element 100 is not limited to this. The semiconductor element 100 includes a substrate 10, an intermediate layer 20, a buffer region 30 formed above the substrate 10, an active layer 70 formed on the buffer region 30, and at least two electrodes formed on the active layer 70, which in the present example are a source electrode 72, a gate electrode 74, and a drain electrode 76.

The substrate 10 functions as a support body for the first buffer region 30 and the active layer 70. The substrate 10 may be a monocrystalline silicon substrate with the

(111) surface as the primary surface. The substrate 10 may have a diameter of approximately 10 cm, for example.

The intermediate layer 20 is layered on the primary surface of the substrate 10, and has the same function and configuration as the intermediate layer 20 described in relation to Fig. 1. The lattice constant of the intermediate layer 20 may be less than that of the substrate 10. Furthermore, the thermal expansion coefficient of the intermediate layer 20 may be greater than that of the substrate 10. If the substrate 10 is a silicon substrate, the lattice constant is 0.384 nm and the thermal expansion coefficient is 3.59×10⁻⁶/K. If the intermediate layer 20 is formed of AlN, the lattice constant of the intermediate layer 20 is 0.3112 nm and the thermal expansion coefficient is 4.2×10⁻⁶/K. The thickness of the intermediate layer 20 is 40 nm, for example.

The buffer region 30 includes at least one composite layer 35, which is formed by layering a first semiconductor layer 31 having a first lattice constant, a second semiconductor layer 32 having a second lattice constant, and a third semiconductor layer 33 having a third lattice constant differing from the first lattice constant, in the stated order. The second lattice constant is a value between the values of the first lattice constant and the third lattice constant. The first semiconductor layer 31 is formed on the intermediate layer 20. The first semiconductor layer 31 may have a first lattice constant that is smaller than the lattice constant of the substrate 10. The first semiconductor layer 31 may have a larger thermal expansion coefficient than the substrate 10. The first semiconductor layer 31 includes Alₓ₁In_{y1}Ga_{1-x1-y1}N, where 0 ≤ x1 < 1, 0 ≤ yl ≤ 1, and x1 + yl ≤ 1. The first semiconductor layer 31 is GaN, for example. In this case, the first lattice constant of the first semiconductor layer 31 is 0.3189 nm and the thermal expansion coefficient is 5.59×10⁻⁶/K.

The second semiconductor layer 32 is formed in contact with the first semiconductor layer 31. The second semiconductor layer 32 has a second lattice constant with a value between the values of the first lattice constant and the third lattice constant. The second lattice constant is less than the first lattice constant. The second semiconductor layer 32 has a thermal expansion coefficient that is between those of the first semiconductor layer 31 and the third semiconductor layer 33. The second semiconductor layer 32 may include Alₓ₂In_{y2}Ga_{1-x2-y2}N, where 0 < x2 ≤ 1, 0 ≤ y2 ≤ 1, and x2 + y2 ≤ 1. The second semiconductor layer 32 is AlGaN, for example. The second semiconductor layer 32 has a thermal expansion coefficient that is between those of GaN and AlN and a lattice constant that corresponds to the Al composition ratio. In the second semiconductor layer 32, the lattice constant may decrease in a direction from a side closer to the substrate 10 to a side farther from the substrate 10. For example, the second semiconductor layer 32 may be AlGaN in which the Al ratio increases in a direction from a side closer to the substrate 10 to a side farther from the substrate 10.

The second semiconductor layer 32 is doped with impurities. The impurities include atoms that do not activate electrons. "Atoms that do not activate electrons" are atoms that form ions forming the acceptor level or ions with a deep level that can trap electrons. The impurities implanted in the second semiconductor layer 32 may be at least one of carbon, fluorine, chlorine, magnesium, iron, oxygen, hydrogen, zinc, bronze, silver, gold, nickel, cobalt, vanadium, scandium, lithium, sodium, beryllium, and boron. If the impurity is carbon, the second semiconductor layer 32 may be doped to a dopant concentration of approximately 1E19 cm⁻³, by introducing propane gas.

The third semiconductor layer 33 is formed in contact with the second semiconductor layer 32. The third semiconductor layer 33 may have a third lattice constant that is smaller than the first lattice constant. The third semiconductor layer 33 may include Alₓ₃In_{y3}Ga_{1-x3-y3}N, where 0 < x3 ≤ 1, 0 ≤ y3 ≤ 1, and x3 + y3 ≤ 1. The third semiconductor layer 33 is AlN, for example. In this case, the third lattice constant of the third semiconductor layer 33 is 0.3112 nm and the thermal expansion coefficient is 4.2×10⁻⁶/K. Concerning the Al composition ratio from the first semiconductor layer 31 to the third semiconductor layer 33, there is a relationship of x1 ≤ x2 ≤ x3.

The buffer region 30 lessens the strain caused by the difference in thermal expansion coefficients and the difference in lattice constants between the substrate 10 and the active layer 70. The buffer region 30 includes twelve composite layers 35 that are each formed by layering a first semiconductor layer 31, a second semiconductor layer 32, and a third semiconductor layer 33, for example. The thicknesses of the first semiconductor layers 31 in the composite layers 35 are respectively 70 nm, 90 nm, 120 nm, 150 nm, 190 nm, 240 nm, 300 nm, 370 nm, 470 nm, 600 nm, 790 nm, and 1040 nm in order from the substrate 10 side. The thickness of each second semiconductor layer 32 may be a constant 60 nm, for example. The thickness of each third semiconductor layer 33 may be a constant 60 nm, for example.

The active layer 70 includes an electron transit layer 50 and an electron supply layer 60. The electron transit layer 50 is formed in contact with the topmost third semiconductor layer 33. The electron transit layer 50 forms two-dimensional electron gas with low resistance at the heterojunction interface between the electron transit layer 50 and the electron supply layer 60. The electron transit layer 50 may include undoped GaN. The electron transit layer 50 has a thickness of 1200 nm, for example. The electron supply layer 60 is formed in contact with the electron transit layer 50. The electron supply layer 60 supplies electrons to the electron transit layer 50. The electron supply layer 60 includes AlGaN doped with n-type impurities such as Si, for example. The electron supply layer 60 has a thickness of 25 nm, for example.

The source electrode 72 and the drain electrode 76 may have a Ti/Al layered structure and ohmically contact the electron supply layer 60. The gate electrode 74 may have a Pt/Au layered structure and is in Schottky contact with the electron supply layer 60.

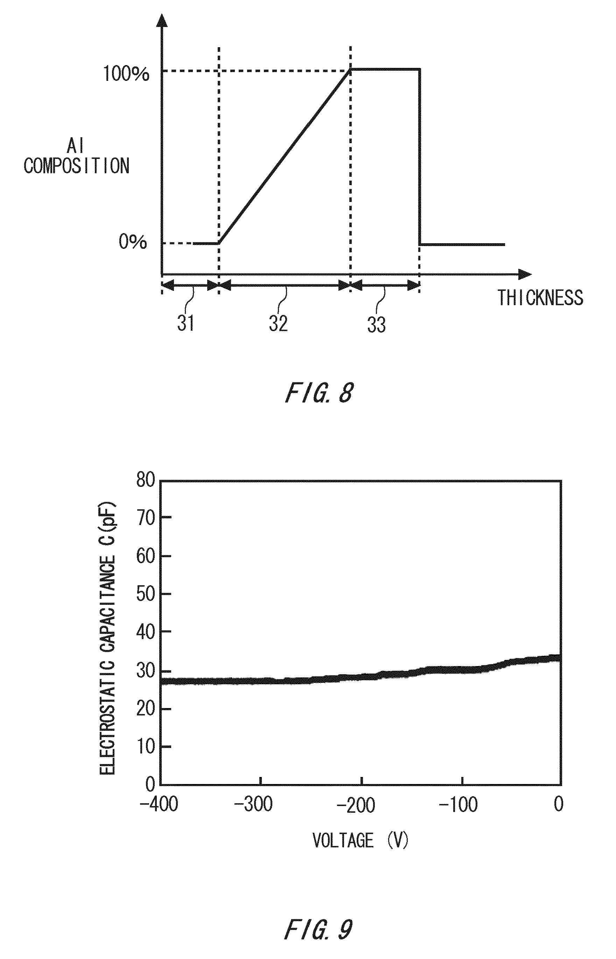

Fig. 8 shows change in the Al composition of the buffer region 30 in a thickness direction. Here, the Al ratio of the first semiconductor layer 31 is shown as 0% and the Al ratio of the third semiconductor layer 33 is shown as 100%, but the Al compositions are not limited to this. The Al composition ratio of the second semiconductor layer 32 increases linearly in a direction from the first semiconductor layer 31 to the third semiconductor layer 33.

Fig. 9 shows the voltage-electrostatic capacitance characteristic of the buffer region 30 of the semiconductor element 100. In the present example, the Schottky electrode 13 shown in Fig. 1 was formed on the top surface of the electron transit layer 50 of the semiconductor element 100 to measure the characteristic. If the topmost later of the buffer region 30 is a GaN layer, the Schottky electrode 13 may be formed on the top surface of this GaN layer. In the present example, the second semiconductor layer 32 is doped with carbon by forming the second semiconductor layer 32 while introducing 750 ccm of propane gas. Furthermore, there are six composite layers 35, and the thickness of the second semiconductor layer 32 in each composite layer 35 is 180 nm. The other measurement conditions are the same as the measurement conditions described in Fig. 2.

By doping the second semiconductor layer 32 with carbon, the amount of change of the electrostatic capacitance is less than in the epitaxially layered body 300 shown in Fig. 1. However, the electrostatic capacitance decreases in a stepped manner as the voltage applied in the layering direction decreases. Accordingly, it is understood that the buffer region 30 of the present example has carriers remaining in the composite layers 35.

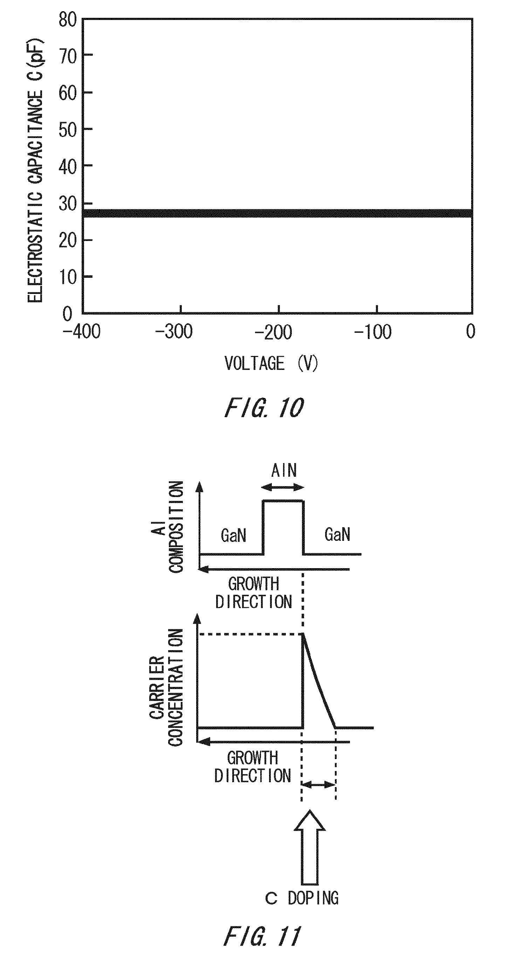

Fig. 10 shows the voltage-electrostatic capacitance characteristic of the buffer region 30 when the amount of carbon implanted in the second semiconductor layer 32 is increased. In this example, the second semiconductor layer 32 was formed while introducing 1500 ccm of propane gas. The other measurement conditions are the same as in the example of Fig. 9.

In this example, no change was seen in the electrostatic capacitance even when the voltage applied in the layering direction decreases. In other words, by adjusting the impurity concentration in the second semiconductor layer 32, a buffer region 30 having a substantially constant voltage-electrostatic capacitance characteristic was able to be formed. Therefore, the leak current through the buffer region 30 can be decreased in the semiconductor element 100.

It is preferable to dope the second semiconductor layer 32 with impurities that cause the electrostatic capacitance between the bottom surface of the substrate 10 and the top surface of the buffer region 30 to be substantially constant when voltage is applied between the bottom surface of the substrate 10 and the top surface of the buffer region 30 and this voltage is changed within a range according to the thickness of the buffer region 30. Here, "substantially constant" may refer to the change of the electrostatic capacitance for this voltage range being in a range up to 20% of the electrostatic capacitance value, for example. Instead, "substantially constant" may refer to this change being in a range up to 10% or up to 5% of the electrostatic capacitance value.

The potential applied to the top surface of the buffer region 30 is lower than the potential applied to the bottom surface of the substrate. Specifically, a positive or zero potential may be applied to the bottom surface of the substrate 10, and a negative potential may be applied to the top surface of the buffer region 30.

The voltage range corresponding to the thickness of the buffer region 30 may refer to a range whose upper and lower limits of voltage that can cause depletion of the buffer region 30 from the Schottky electrode 13 to the substrate 10. Furthermore, 0 V may be used as the upper or lower limit for this voltage range. For example, the voltage range may be from 0 V to -500 V, or from 0 V to -300 V.

Fig. 11 schematically shows an example of implanting C in the surface of the GaN layer on the AlN layer side in a composite layer formed by sequentially depositing GaN layers and AlN layers. As described in Fig. 4, the carrier concentration exhibits a sudden peak at the heterojunction interface between the GaN layer and the AlN layer on the GaN layer. As described in Fig. 6, the peak value of the carrier concentration is 4.95E+20 cm⁻³. In order to compensate for the carrier with this concentration by doping with carbon, it is necessary to dope with approximately the same amount of C. However, when the surface of the GaN layer is doped with such a high concentration of C, the crystal surface becomes undesirably rough.

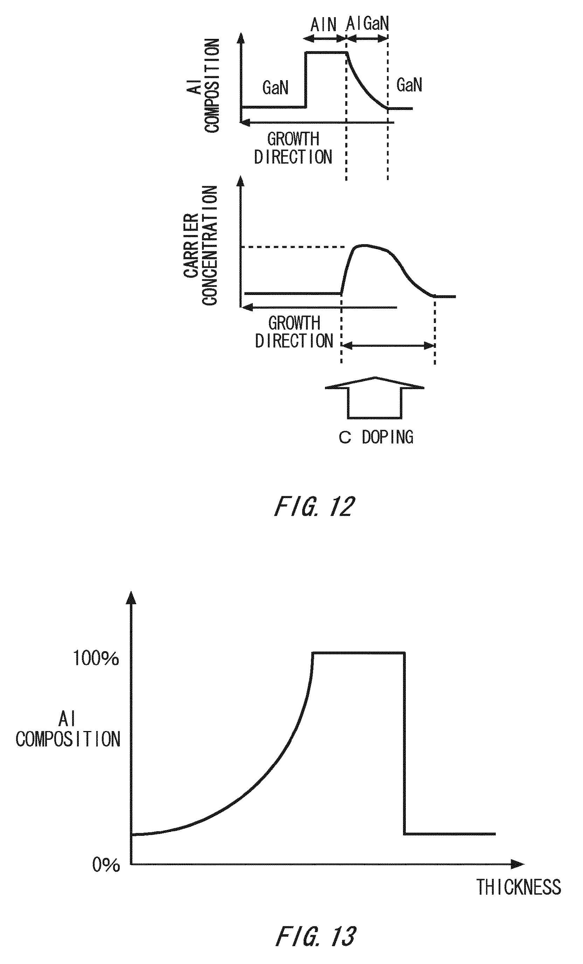

Fig. 12 schematically shows an example in which C is implanted in the AlGaN layer of a composite layer 35 formed by sequentially depositing a first semiconductor layer 31 (GaN layer), a second semiconductor layer 32 (AlGaN layer), and a third semiconductor layer 33 (AlN layer). As described in Fig. 6, the peak value of the carrier concentration in the AlGaN layer decreases according to the thickness of the AlGaN layer. In other words, the AlGaN layer functions to scatter the carriers. By implanting C with a concentration equivalent to that of the scattered carriers, the carrier can be compensated. For example, by doping the entirety of the AlGaN layer with approximately 1E19 cm⁻³ to 5E19 cm⁻³ of C, the carriers of the AlGaN layer can be compensated. Furthermore, since the carriers are also scattered in the GaN layer contacting the AlGaN layer from below and the AlN layer contacting the AlGaN layer from above, these layers also become doped with C.

The leak current flowing through the drain electrode 76 was measured by applying a voltage of -6 V to the gate electrode 74 and a voltage of 600 V between the source electrode 72 and the drain electrode 76 of a semiconductor element 100 in which the width of the gate electrode 74 is 1 mm, the length of the gate electrode 74 is 10 µm, and the distance between the source electrode 72 and the drain electrode 76 is 15 µm. The leak current of the semiconductor element 100 was a favorable value of approximately 1E-8 A. In an example where the buffer region 30 was formed while replacing the second semiconductor layer 32 with the first semiconductor layer 31, the leak current increased to approximately 1E-6 A. This is believed to be because two-dimensional electron gas is generated and the carrier cannot be compensated through only C doping. Furthermore, in an example where the second semiconductor layer 32 was formed with a C doping concentration of 1E17 cm⁻³, the leak current increased to approximately 1E-5 A. This is believed to be because, with a dopant concentration of approximately 1E17 cm⁻³, the carriers cannot be compensated by only the second semiconductor layer 32, and also because the lower growth rate of the second semiconductor layer 32 relative to the first semiconductor layer 31 causes a reduction in the amount of C acquired from the group III material, which results in an increase in the n-type carrier concentration in the second semiconductor layer 32.

Fig. 13 shows another example of Al composition ratio change in the second semiconductor layer 32. The C doping concentration was set to 1E19 cm⁻³. The Al increases in a curved manner from the first semiconductor layer 31 to the third semiconductor layer 33. The increase in the Al composition ratio has a greater slope closer to the third semiconductor layer 33. When the second semiconductor layer 32 is configured in this way, the leak current of the semiconductor element 100 can be decreased.

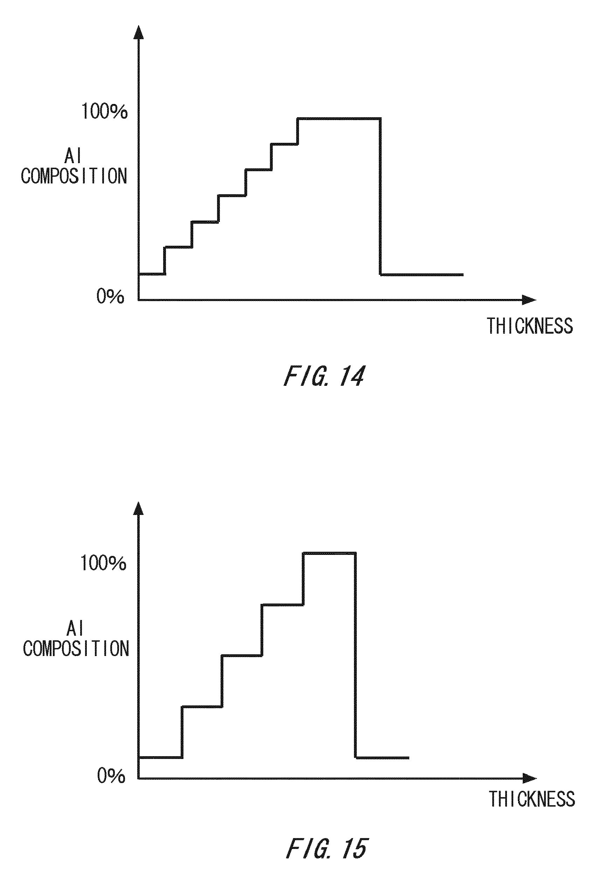

Fig. 14 shows another example of Al composition ratio change in the second semiconductor layer 32. The C doping concentration was set to 1E19 cm⁻³. The Al increases in steps of 5% from the first semiconductor layer 31 to the third semiconductor layer 33. When the second semiconductor layer 32 is configured in this way, the leak current of the semiconductor element 100 can be decreased.

Fig. 15 shows another example of Al composition ratio change in the second semiconductor layer 32. The C doping concentration was set to 1E19 cm⁻³. The Al increases in steps of 25% from the first semiconductor layer 31 to the third semiconductor layer 33. When the second semiconductor layer 32 is configured in this way, the leak current of the semiconductor element 100 can be decreased.

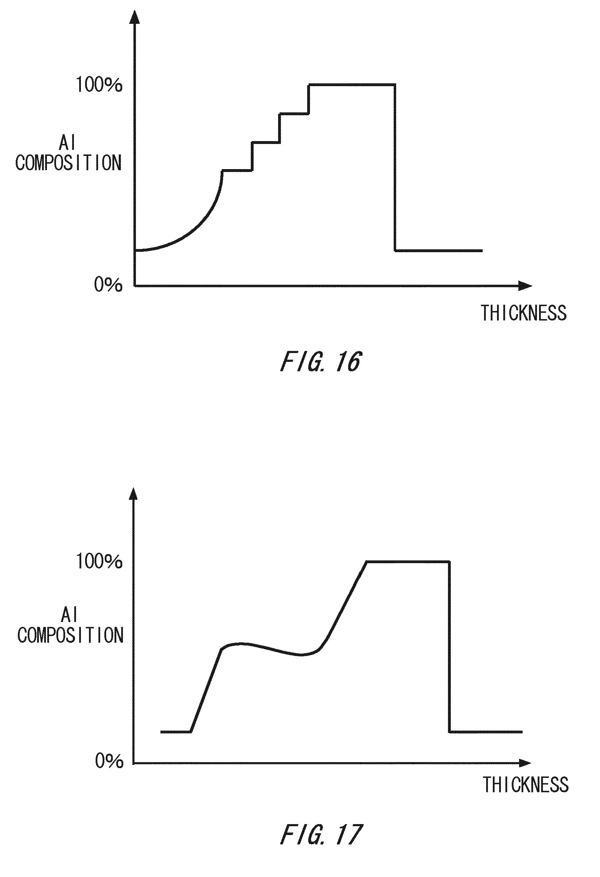

Fig. 16 shows another example of Al composition ratio change in the second semiconductor layer 32. The C doping concentration was set to 1E19 cm⁻³. The Al increases from the first semiconductor layer 31 to the third semiconductor layer 33 as a curve until a midway point, and then increases in steps. In the region where the Al composition ratio changes as a curve, the slope of the increase in the Al composition ratio is greater closer to the third semiconductor layer 33. When the second semiconductor layer 32 is configured in this way, the leak current of the semiconductor element 100 can be decreased.

Fig. 17 shows another example of Al composition ratio change in the second semiconductor layer 32. The C doping concentration was set to 1E19 cm⁻³. The Al increases from the first semiconductor layer 31 to the third semiconductor layer 33 linearly until a midway point, temporarily decreases, and then returns to increasing linearly. When the second semiconductor layer 32 is configured in this way, the leak current of the semiconductor element 100 can be decreased.

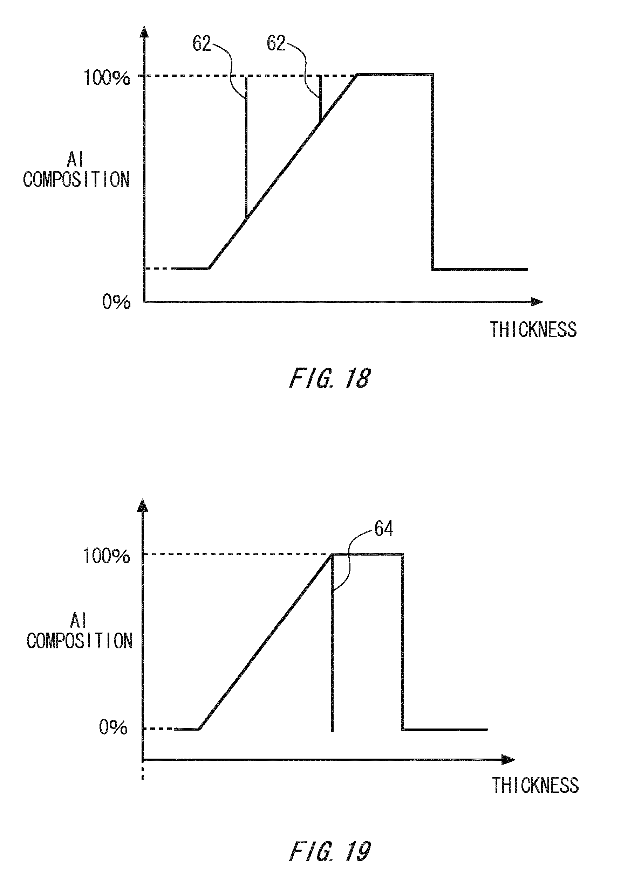

Fig. 18 shows another example of Al composition ratio change in the second semiconductor layer 32. The C doping concentration was set to 1E19 cm⁻³. The second semiconductor layer 32 includes a layer 62 that is thinner than the third semiconductor layer 33 and has the same composition as the third semiconductor layer 33, at a position distanced from the third semiconductor layer 33. An AlN layer with a thickness of 1 nm, for example, is included within the second semiconductor layer 32. The second semiconductor layer 32 may include a plurality of layers 62 arranged at uniform intervals therein. In this way, warpage of the overall substrate can be controlled. When the second semiconductor layer 32 is configured in this way, the leak current of the semiconductor element 100 can be decreased.

Fig. 19 shows another example of Al composition ratio change in the second semiconductor layer 32. The C doping concentration was set to 1E19 cm⁻³. The second semiconductor layer 32 includes a layer 64 that is thinner than the third semiconductor layer 33 and has a composition differing from that of the layer contacting the second semiconductor layer 32 at the interface, at least at one of the interface with the first semiconductor layer 31 and the interface with the third semiconductor layer 33. For example, the second semiconductor layer 32 may include a layer 64 that has the same composition as the first semiconductor layer 31, at the interface with the third semiconductor layer 33. More specifically, the second semiconductor layer 32 may include a GaN layer with a thickness of 1 nm, for example, at the interface with the third semiconductor layer 33. In this way, the crystallinity of the surface of the buffer region 30 is improved. When the second semiconductor layer 32 is configured in this way, the leak current can be decreased.

The following describes a method for manufacturing the semiconductor element 100. The semiconductor element 100 manufacturing method includes a step of preparing the substrate 10, a step of forming the intermediate layer 20 on the substrate 10, a step of forming the buffer region 30 on the intermediate layer 20 above the substrate 10, a step of forming the active layer 70 on the buffer region 30, and a step of forming at least two electrodes (72, 74, 76) on the active layer 70.

The step of preparing the substrate 10 includes a step of preparing a Si (110) or a Si (111) substrate formed using the CZ technique. The step of forming the intermediate layer 20 includes a step of epitaxially growing and depositing AlN with a thickness of approximately 40 nm on the primary surface of the substrate 10, by using TMA (trimethylaluminum) gas and NH₃ gas, through MOCVD (Metal Organic Chemical Vapor Deposition) while maintaining a temperature of 1100°C. In the following example, the epitaxial growth is performed using MOCVD. The growth temperature for each layer may be no less than 900°C and no greater than 1300°C.

The step of forming the buffer region 30 includes performing, at least once, a cycle including a step of forming the first semiconductor layer 31 having a first lattice constant, a step of forming the second semiconductor layer 32 having a second lattice constant, and a step of forming the third semiconductor layer having a third lattice constant that differs from the first lattice constant, in the stated order. The third lattice constant differs from the first lattice constant. The second lattice constant is a value between the values of the first lattice constant and the third lattice constant. The first lattice constant may be smaller than the lattice constant of the substrate 10. The second lattice constant may be smaller than the first lattice constant.

The step of forming the first semiconductor layer 31 includes a step of, after forming the intermediate layer 20, supplying TMG (trimethylgallium) gas and NH₃ gas to epitaxially grow and deposit GaN on the intermediate layer 20. The step of forming the second semiconductor layer 32 includes a step of supplying TMG gas, TMA gas, and NH₃ gas to epitaxially grow and deposit AlGaN with a thickness of 60 nm on the first semiconductor layer 31. At this time, the second semiconductor layer 32 can be formed with a graded Al composition ratio, by gradually increasing the flow rate of the TMA gas.

The step of forming the second semiconductor layer 32 includes a step of doping with impurities. The impurities include atoms that do not activate electrons. Specifically, the impurities include at least one of carbon, fluorine, chlorine, magnesium, iron, oxygen, hydrogen, zinc, bronze, silver, gold, nickel, cobalt, vanadium, scandium, lithium, sodium, beryllium, and boron. If the impurity is carbon, the second semiconductor layer 32 can be doped with C by introducing propane gas at the same time. Controlling the C doping amount is achieved by controlling the flow rate of the propane gas. When not doping with propane gas, the C doping concentration can be controlled by adjusting growth conditions such as the growth rate, the growth temperature, the group V to group III ratio, or the growth pressure. The step of forming the third semiconductor layer 33 includes a step of providing TMA gas and NH₃ gas to epitaxially grow and deposit AlN with a thickness of 60 nm on the second semiconductor layer 32.

The step of forming the buffer region 30 includes repeating, at least once, a cycle including a step of forming the first semiconductor layer 31, a step of forming the second semiconductor layer 32, and a step of forming the third semiconductor layer 33, in the stated order. Each performance of this cycle results in the formation of a composite layer 35 including a first semiconductor layer 31, a second semiconductor layer 32, and a third semiconductor layer 33. A step is included to change the thicknesses of the first semiconductor layers 31 in the composite layers 35 to be respectively 70 nm, 90 nm, 120 nm, 150 nm, 190 nm, 240 nm, 300 nm, 370 nm, 470 nm, 600 nm, 790 nm, and 1040 nm in order from the substrate 10 side, by adjusting the growth time.

The step of forming the active layer 70 includes a step of forming the electron transit layer 50 and a step of forming the electron supply layer 60 on the electron transit layer 50. The step of forming the electron transit layer 50 includes a step of supplying TMG gas and NH3 gas to epitaxially grow and deposit GaN with a thickness of 1200 nm on the topmost third semiconductor layer 33 of the buffer region 30. The step of forming the electron supply layer 60 includes a step of epitaxially growing and depositing AlGaN doped with Si with a thickness of 25 nm on the electron transit layer 50, by supplying TMA gas, TMG gas, NH₃ gas, and SiH₄ gas.

The step of forming at least two electrodes (72, 74, 76) includes a step of forming a silicon oxide film on the surface of the substrate 10, a step of forming openings for the electrodes, and a step of forming the electrodes. The step of forming a silicon oxide film on the surface of the substrate 10 includes a step of removing the substrate 10 from an MOCVD apparatus, transporting the substrate 10 into a plasma CVD apparatus, and forming the silicon oxide film over the entire surface of the substrate 10. The step of forming the openings for the electrodes includes the step of forming openings for the source electrode and the drain electrode through photolithography and etching, and the step of forming the electrodes includes a step of sequentially layering Ti and Al using electron beam deposition to form the source electrode 72 and the drain electrode 76 ohmically contacting the electron supply layer 60, using a liftoff technique. The step of forming the opening for the electrodes also includes forming an opening for the gate electrode through photolithography and etching, and the step of forming the electrodes also includes sequentially layering Pt and Au using electron beam deposition to form the gate electrode 74 in Schottky contact with the electron supply layer 60, using a liftoff technique.

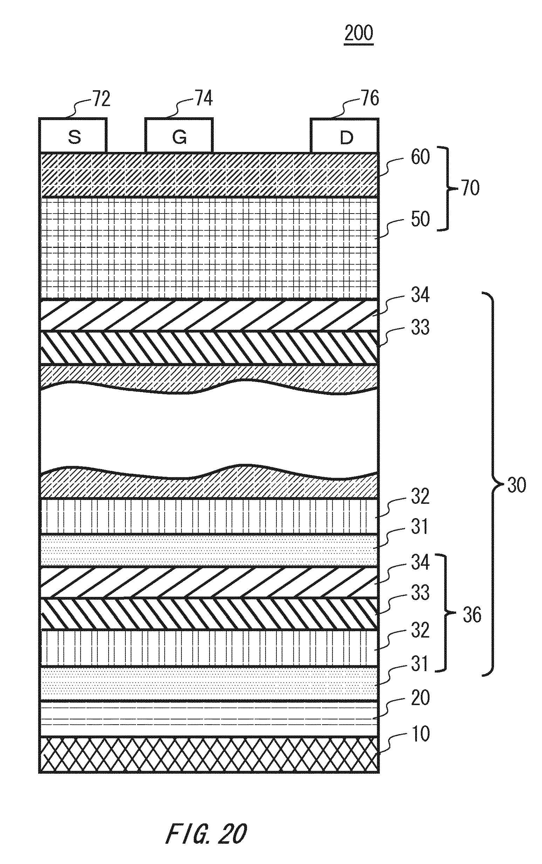

Fig. 20 is a cross-sectional view of a semiconductor element 200 according to a second embodiment of the present invention. The semiconductor element 200 differs from the semiconductor element 100 with respect to the configuration of the buffer region 30. Aside from the configuration of the buffer region 30, the semiconductor element 200 may be the same as the semiconductor element 100.

The buffer region 30 includes at least one composite layer 36, which is formed by sequentially layering a first semiconductor layer 31 having a first lattice constant, a second semiconductor layer 32 having a second lattice constant, a third semiconductor layer 33 having a third lattice constant, and a fourth semiconductor layer 34 having a fourth lattice constant, in the stated order. The third lattice constant differs from the first lattice constant. The second lattice constant is a value between the values of the first lattice constant and the third lattice constant. The fourth semiconductor layer 34 is formed on the third semiconductor layer 33 in contact with the third semiconductor layer 33. The fourth semiconductor layer 34 has a fourth lattice constant that is between the first lattice constant and the third lattice constant. The fourth semiconductor layer 34 has a thermal expansion coefficient that is between the thermal expansion coefficient of the first semiconductor layer 31 and the thermal expansion coefficient of the third semiconductor layer 33. The fourth semiconductor layer 34 includes Alₓ₄In_{y4}Ga_{1-x4-y4}N, where 0 < x4 < 1, 0 ≤ y4 ≤ 1, and x4 + y4 ≤ 1.

The fourth semiconductor layer 34 is AlGaN, for example. The fourth semiconductor layer 34 has a thermal expansion coefficient and lattice constant corresponding to the Al composition ratio. In the fourth semiconductor layer 34, the lattice constant decreases in a direction from a side closer to the substrate 10 to a side farther from the substrate 10. In other words, in the fourth semiconductor layer 34, the Al ratio decreases in a direction from a side closer to the substrate 10 to a side farther from the substrate 10. Concerning the Al composition ratio from the first semiconductor layer 31 to the fourth semiconductor layer 34, there is a relationship of x1 ≤ x2 and x4 ≤ x3.

In the buffer region 30, at least one of the second semiconductor layer 32 and the fourth semiconductor layer 34 is doped with impurities. The impurities include atoms that do not activate electrons. "Atoms that do not activate electrons" are atoms that form ions forming the acceptor level or ions with a deep level that can trap electrons. The impurities include at least one of carbon, fluorine, chlorine, magnesium, iron, oxygen, hydrogen, zinc, bronze, silver, gold, nickel, cobalt, vanadium, scandium, lithium, sodium, beryllium, and boron. If the impurity is carbon, the second semiconductor layer 32 and the fourth semiconductor layer 34 may be doped with C to a dopant concentration of approximately 1E19 cm⁻³, by introducing propane gas.

The impurities may include atoms that do not activate holes. "Atoms that do not activate holes" are atoms that form ions forming the donor level or ions with a deep level that can trap holes. The impurities include at least one of silicon, oxygen, germanium, phosphorous, arsenic, and antimony. If the impurities are silicon, the fourth semiconductor layer 34 may be doped with Si to a doping concentration of 1E19 cm⁻³, by introducing silane gas. The impurities may be implanted in both the second semiconductor layer 32 and the fourth semiconductor layer 34, or in only the second semiconductor layer 32. The impurities may be atoms that do not activate electrons, and may be atoms that do not activate holes. Since electrons and holes are generated in pairs, the generation of two-dimensional electron gas can be restricted by reducing the two-dimensional hole gas.

The buffer region 30 includes twelve composite layers 36 that each include a first semiconductor layer 31, a second semiconductor layer 32, a third semiconductor layer 33, and a fourth semiconductor layer 34, layered in the stated order. The thicknesses of the first semiconductor layers 31 in the composite layers 36 are respectively 10 nm, 30 nm, 60 nm, 90 nm, 130 nm, 180 nm, 230 nm, 310 nm, 410 nm, 540 nm, 730 nm, and 980 nm in order from the substrate 10 side. The thickness of each second semiconductor layer 32 may be a constant 60 nm, for example. The thickness of each third semiconductor layer 33 may be a constant 60 nm, for example. The thickness of each fourth semiconductor layer 34 may be a constant 60 nm, for example.

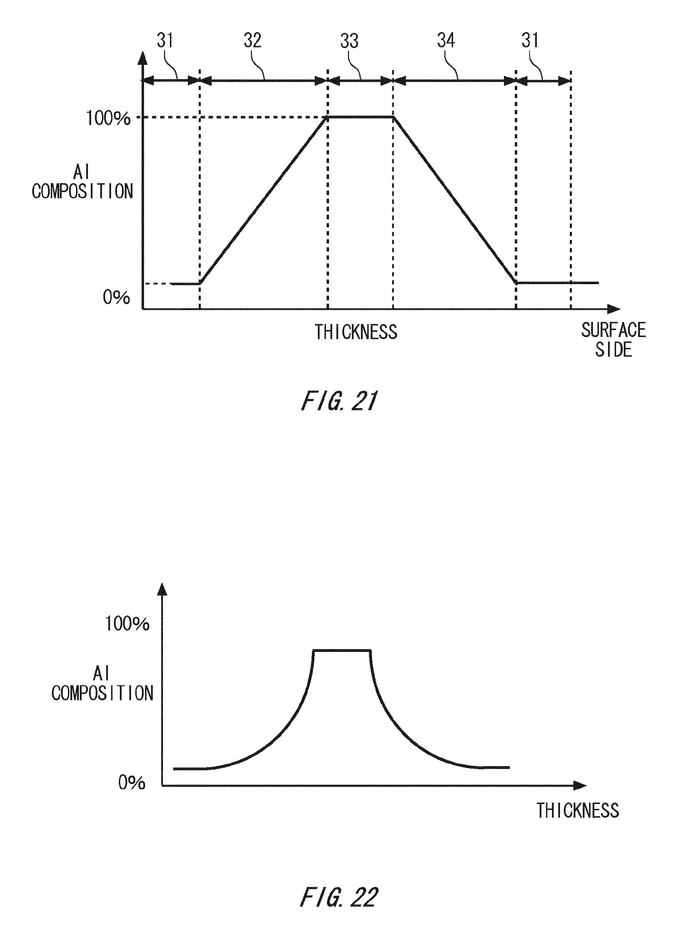

Fig. 21 shows change in Al composition in the layering direction of the buffer region 30. Here, the Al ratio of the first semiconductor layer 31 is shown as 0% and the Al ratio of the third semiconductor layer 33 is shown as 100%, but the Al compositions are not limited to this. The Al composition ratio of the second semiconductor layer 32 increases linearly in a direction from the first semiconductor layer 31 to the third semiconductor layer 33. The Al composition ratio of the fourth semiconductor layer 34 decreases linearly in a direction from the third semiconductor layer 33 to the first semiconductor layer 31. Using the same conditions such as the thickness of each layer, the material used in each layer, and the applied voltage that were used for the semiconductor element 100, the leak current of the semiconductor element 200 was measured. The measurement results indicated that the leak current was approximately 1E-9 A, which is lower than in the semiconductor element 100.

The following describes a method for manufacturing the semiconductor element 200 according to the second embodiment of the present invention. Aside from the step of forming the buffer region 30, the semiconductor element 200 manufacturing method is the same as the semiconductor element 100 manufacturing method, and therefore redundant descriptions are omitted. The step of forming the buffer region 30 includes performing, at least once, a cycle including a step of forming the first semiconductor layer 31 having a first lattice constant, a step of forming the second semiconductor layer 32 having a second lattice constant, a step of forming the third semiconductor layer 33 having a third lattice constant, and a step of forming a fourth semiconductor layer 34 having a lattice constant between the first lattice constant and the third lattice constant, in the stated order. The third lattice constant differs from the first lattice constant. The fourth lattice constant is a value between the values of the first lattice constant and the third lattice constant. The second lattice constant is a value between the values of the first lattice constant and the third lattice constant.

The step of forming the first semiconductor layer 31 includes a step of, after forming the intermediate layer 20, supplying TMG (trimethylgallium) gas and NH₃ gas to epitaxially grow and deposit GaN on the intermediate layer 20. The step of forming the second semiconductor layer 32 includes a step of supplying TMG gas, TMA gas, and NH₃ gas to epitaxially grow and deposit AlGaN with a thickness of 60 nm on the first semiconductor layer 31. At this time, the second semiconductor layer 32 can be formed with a graded Al composition ratio, by gradually increasing the flow rate of the TMA gas.

At least one of the step of forming the second semiconductor layer 32 and the step of forming the fourth semiconductor layer 34 includes a step of doping with impurities. The step of forming the second semiconductor layer 32 may include a step of doping with impurities. The impurities include atoms that do not activate electrons. Specifically, the impurities include at least one of carbon, fluorine, chlorine, magnesium, iron, oxygen, hydrogen, zinc, bronze, silver, gold, nickel, cobalt, vanadium, scandium, lithium, sodium, beryllium, and boron. If the impurity is carbon, the second semiconductor layer 32 can be doped with C by introducing propane gas at the same time. In this case, controlling the C doping amount is achieved by controlling the flow rate of the propane gas. When not doping with propane gas, the C doping concentration can be controlled by adjusting growth conditions such as the growth rate, the growth temperature, the group V to group III ratio, or the growth pressure. The step of forming the third semiconductor layer 33 includes a step of providing TMA gas and NH₃ gas to epitaxially grow and deposit AlN with a thickness of 60 nm on the second semiconductor layer 32.

The step of forming the fourth semiconductor layer 34 includes a step of supplying TMG gas, TMA gas, and NH₃ gas to epitaxially grow and deposit AlGaN with a thickness of 60 nm on the third semiconductor layer 33. At this time, the fourth semiconductor layer 34 can be formed with a graded Al composition ratio, by gradually decreasing the flow rate of the TMA gas.

The step of forming the fourth semiconductor layer 34 may include a step of doping with impurities. The impurities may be the atoms that do not activate electrons, as described above. Furthermore, the impurities may be atoms that do not activate holes. Specifically, the impurities that do not activate holes include at least one of silicon, oxygen, germanium, phosphorous, arsenic, and antimony. If the impurities are silicon, the fourth semiconductor layer 34 may be doped with Si by introducing silane gas at the same time. The Si doping concentration can be controlled by controlling the flow rate of the silane gas. The doping with impurities may be performed on just the second semiconductor layer 32, just the fourth semiconductor layer 34, or both the second semiconductor layer 32 and the fourth semiconductor layer 34. The second semiconductor layer 32 and the fourth semiconductor layer 34 may be doped with the same impurities, or with different impurities. The second semiconductor layer 32 and the fourth semiconductor layer 34 may be doped with two or more different types of atoms. The second semiconductor layer 32 and the fourth semiconductor layer 34 may have the same doping concentrations, or different doping concentrations.

The step of forming the buffer region 30 includes repeating, at least once, a cycle including a step of forming the first semiconductor layer 31, a step of forming the second semiconductor layer 32, a step of forming the third semiconductor layer 33, and a step of forming the fourth semiconductor layer 34, in the stated order. Each performance of this cycle results in the formation of a composite layer 36 including a first semiconductor layer 31, a second semiconductor layer 32, a third semiconductor layer 33, and a fourth semiconductor layer 34. A step is included to change the thicknesses of the first semiconductor layers 31 in the composite layers 36 to be respectively 10 nm, 30 nm, 60 nm, 90 nm, 130 nm, 180 nm, 230 nm, 310 nm, 410 nm, 540 nm, 730 nm, and 980 nm in order from the substrate 10 side, by adjusting the growth time.

Fig. 22 shows another example of Al composition ratio change in the second semiconductor layer 32 and the fourth semiconductor layer 34. The C doping concentration in the second semiconductor layer 32 and the fourth semiconductor layer 34 is set to 1E19 cm⁻³. The Al composition ratio of the second semiconductor layer 32 increases in a curved manner from the first semiconductor layer 31 to the third semiconductor layer 33. The increase in the Al composition ratio has a greater slope closer to the third semiconductor layer 33. The Al composition ratio of the fourth semiconductor layer 34 decreases in a curved manner from the third semiconductor layer 33 to the first semiconductor layer 31. The decrease in the Al composition ratio has a greater slope closer to the third semiconductor layer 33. When the second semiconductor layer 32 and the fourth semiconductor layer 34 are configured in this way, the leak current of the semiconductor element 200 is lower than the leak current of the semiconductor element 100.

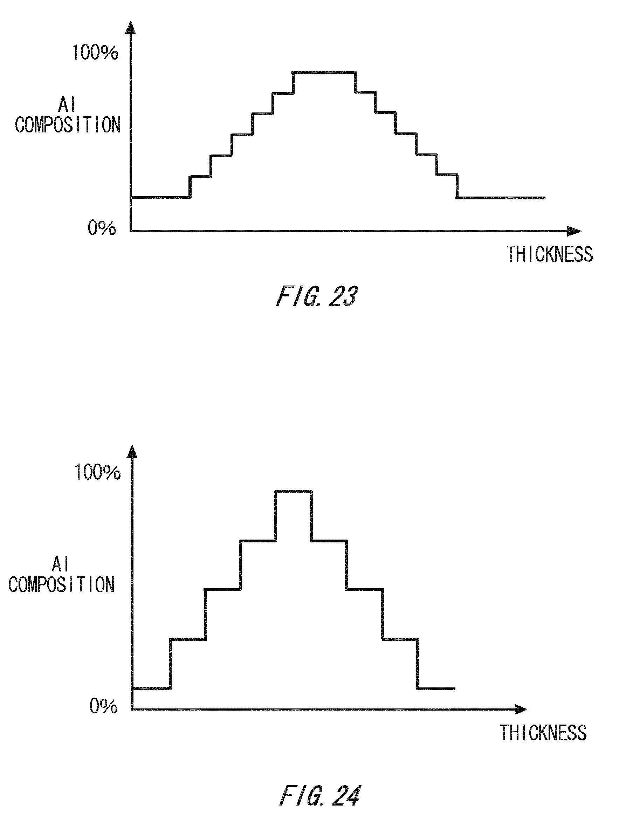

Fig. 23 shows another example of Al composition ratio change in the second semiconductor layer 32 and the fourth semiconductor layer 34. The C doping concentration in the second semiconductor layer 32 and the fourth semiconductor layer 34 is set to 1E19 cm⁻³. The Al composition ratio of the second semiconductor layer 32 increases in steps of 5% from the first semiconductor layer 31 to the third semiconductor layer 33. The Al composition ratio of the fourth semiconductor layer 34 decreases in steps of 5% from the third semiconductor layer 33 to the first semiconductor layer 31. When the second semiconductor layer 32 and the fourth semiconductor layer 34 are configured in this way, the leak current of the semiconductor element 200 is lower than the leak current of the semiconductor element 100.

Fig. 24 shows another example of Al composition ratio change in the second semiconductor layer 32 and the fourth semiconductor layer 34. The C doping concentration in the second semiconductor layer 32 and the fourth semiconductor layer 34 is set to 1E19 cm⁻³. The Al composition ratio of the second semiconductor layer 32 increases in steps of 25% from the first semiconductor layer 31 to the third semiconductor layer 33. The Al composition ratio of the fourth semiconductor layer 34 decreases in steps of 25% from the third semiconductor layer 33 to the first semiconductor layer 31. When the second semiconductor layer 32 and the fourth semiconductor layer 34 are configured in this way, the leak current of the semiconductor element 200 is lower than the leak current of the semiconductor element 100.

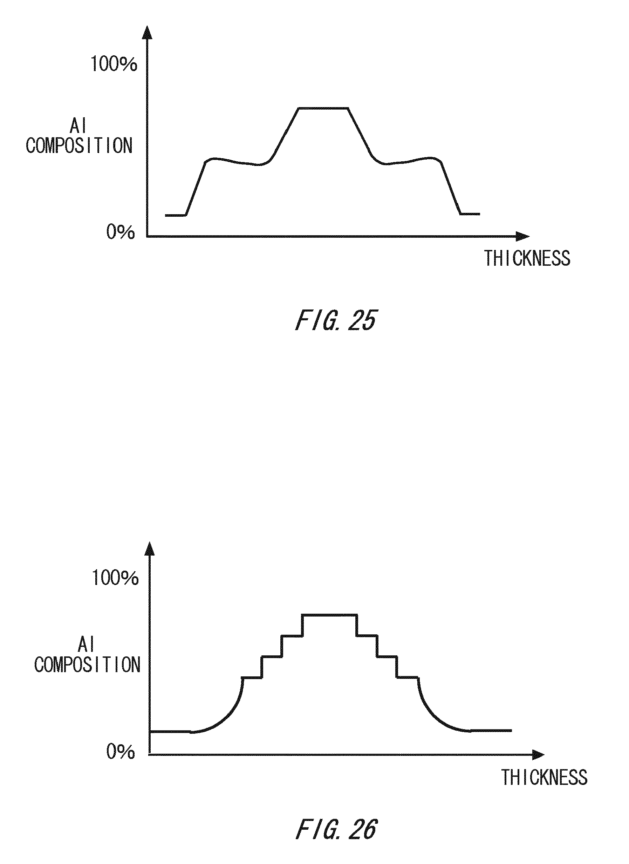

Fig. 25 shows another example of Al composition ratio change in the second semiconductor layer 32 and the fourth semiconductor layer 34. The C doping concentration in the second semiconductor layer 32 and the fourth semiconductor layer 34 is set to 1E19 cm⁻³. The Al composition ratio of the second semiconductor layer 32 increases from the first semiconductor layer 31 to the third semiconductor layer 33 linearly until a midway point, temporarily decreases, and then returns to increasing linearly. The Al composition ratio of the fourth semiconductor layer 34 decreases from the first semiconductor layer 31 to the third semiconductor layer 33 linearly until a midway point, temporarily increases, and then returns to decreasing linearly. When the second semiconductor layer 32 and the fourth semiconductor layer 34 are configured in this way, the leak current of the semiconductor element 200 is lower than the leak current of the semiconductor element 100.

Fig. 26 shows another example of Al composition ratio change in the second semiconductor layer 32 and the fourth semiconductor layer 34. The C doping concentration in the second semiconductor layer 32 and the fourth semiconductor layer 34 is set to 1E19 cm⁻³. The Al composition ratio of the second semiconductor layer 32 increases from the first semiconductor layer 31 to the third semiconductor layer 33 in a curved manner until a midway point, and then increases in steps. In the region where the Al composition ratio changes as a curve, the slope of the increase in the Al composition ratio is greater closer to the third semiconductor layer 33. The Al composition ratio of the fourth semiconductor layer 34 decreases from the third semiconductor layer 33 to the first semiconductor layer 31 in steps until a midway point, and then decreases in a curved manner. In the region where the Al composition ratio changes as a curve, the slope of the decrease in the Al composition ratio is greater closer to the third semiconductor layer 33. When the second semiconductor layer 32 and the fourth semiconductor layer 34 are configured in this way, the leak current of the semiconductor element 200 is lower than the leak current of the semiconductor element 100.

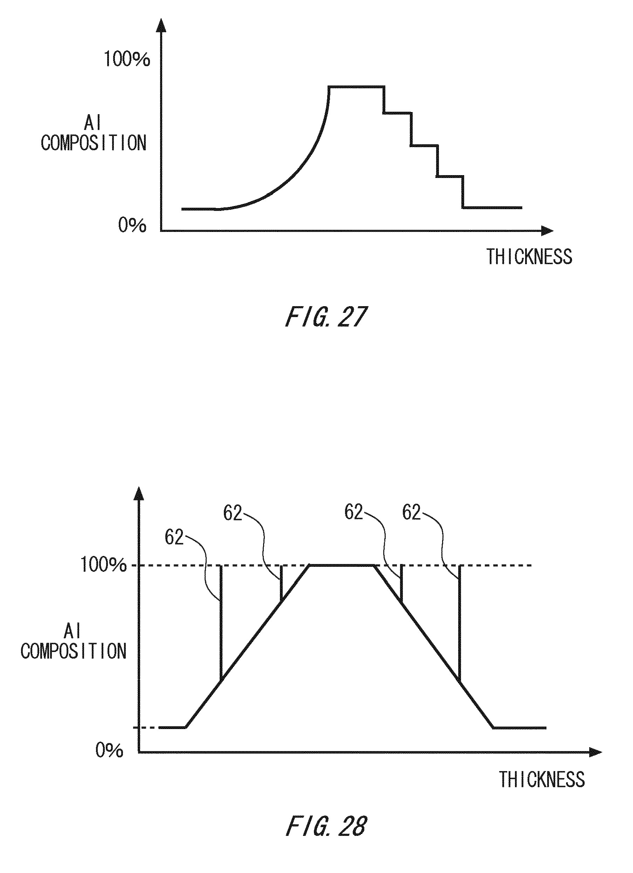

Fig. 27 shows another example of Al composition ratio change in the second semiconductor layer 32 and the fourth semiconductor layer 34. The C doping concentration in the second semiconductor layer 32 and the fourth semiconductor layer 34 is set to 1E19 cm⁻³. The Al composition ratio of the second semiconductor layer 32 increases from the first semiconductor layer 31 to the third semiconductor layer 33 in a curved manner. The slope of the increase in the Al composition ratio is greater closer to the third semiconductor layer 33. The Al composition ratio of the fourth semiconductor layer 34 decreases from the third semiconductor layer 33 to the first semiconductor layer 31 in steps. When the second semiconductor layer 32 and the fourth semiconductor layer 34 are configured in this way, the leak current of the semiconductor element 200 is lower than the leak current of the semiconductor element 100.

Fig. 28 shows another example of Al composition ratio change in the second semiconductor layer 32 and the fourth semiconductor layer 34. The C doping concentration in the second semiconductor layer 32 and the fourth semiconductor layer 34 is set to 1E19 cm⁻³. The second semiconductor layer 32 includes a layer 62 that is thinner than the third semiconductor layer 33 and has the same composition as the layer third semiconductor layer 33, positioned at a distance from the third semiconductor layer 33. The fourth semiconductor layer 34 includes a layer 62 that is thinner than the third semiconductor layer 33 and has the same composition as the third semiconductor layer 33, positioned at a distance from the third semiconductor layer 33. The second semiconductor layer 32 and the fourth semiconductor layer 34 may each include a plurality of layers 62 at uniform intervals. The second semiconductor layer 32 may include therein an AlN layer with a thickness of approximately 1 nm, for example. In this way, warpage of the overall substrate can be controlled. The fourth semiconductor layer 34 may include therein an AlN layer with a thickness of approximately 1 nm, for example. When the second semiconductor layer 32 and the fourth semiconductor layer 34 are configured in this way, the leak current of the semiconductor element 200 is lower than the leak current of the semiconductor element 100.

The second semiconductor layer 32 may include a semiconductor layer that is thinner than the third semiconductor layer 33 at least at one of the interface with the first semiconductor layer 31 and the interface with the third semiconductor layer 33. This semiconductor layer may have a different composition than the layer contacting the second semiconductor layer 32. The fourth semiconductor layer 34 may include a semiconductor layer that is thinner than the third semiconductor layer 33 at least at one of the interface with the first semiconductor layer 31 and the interface with the third semiconductor layer 33. This semiconductor layer may have a different composition than the layer contacting the fourth semiconductor layer 34

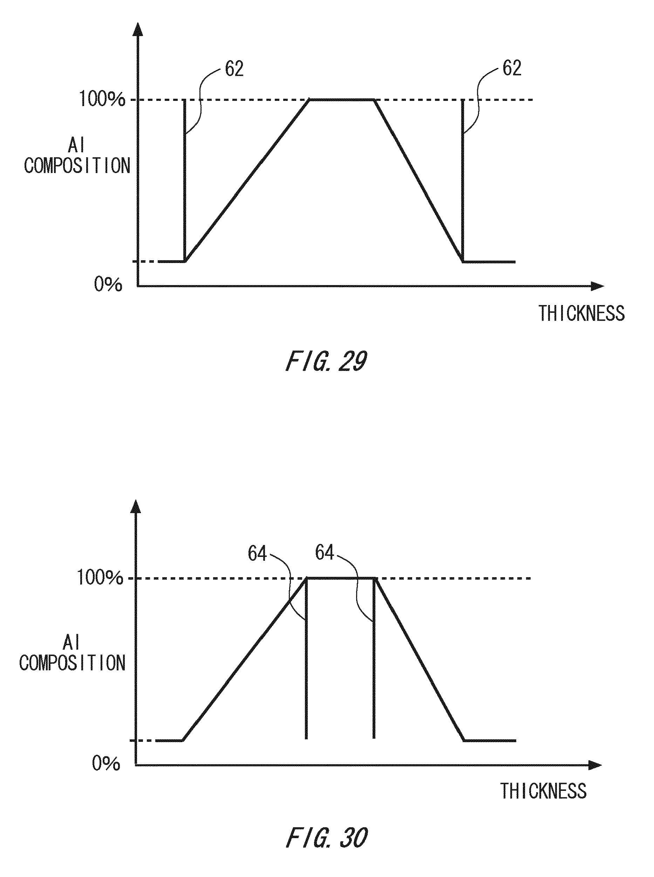

Fig. 29 shows an example of Al composition ratio change when a semiconductor layer 62 that is thinner than the third semiconductor layer 33 is formed at the interface between the first semiconductor layer 31 and the second semiconductor layer 32 and at the interface between the first semiconductor layer 31 and the fourth semiconductor layer 34. The C doping concentration in the second semiconductor layer 32 and the fourth semiconductor layer 34 is set to 1E19 cm⁻³. The second semiconductor layer 32 may include a semiconductor layer 62 with the same composition as the third semiconductor layer 33, at the interface with the first semiconductor layer 31. The semiconductor layer 62 may be an AlN layer with a thickness of approximately 1 nm. The fourth semiconductor layer 34 may include a semiconductor layer 62 at the interface with the first semiconductor layer 31. In this way, warpage in the positive direction can be controlled. When the second semiconductor layer 32 and the fourth semiconductor layer 34 are configured in this way, the leak current of the semiconductor element 200 is lower than the leak current of the semiconductor element 100.

Fig. 30 shows an example of Al composition ratio change when a semiconductor layer 64 that is thinner than the third semiconductor layer 33 is formed at the interface between the second semiconductor layer 32 and the third semiconductor layer 33 and at the interface between the third semiconductor layer 33 and the fourth semiconductor layer 34. The C doping concentration in the second semiconductor layer 32 and the fourth semiconductor layer 34 is set to 1E19 cm⁻³. The second semiconductor layer 32 may include a semiconductor layer 64 with the same composition as the third semiconductor layer 33, at the interface with the third semiconductor layer 33. The semiconductor layer 64 may be a GaN layer with a thickness of approximately 2 nm. The fourth semiconductor layer 34 may include a semiconductor layer 64 at the interface with the third semiconductor layer 33. In this way, the crystallinity of the surface of the buffer region 30 is improved, thereby creating a flatter surface. When the second semiconductor layer 32 and the fourth semiconductor layer 34 are configured in this way, the leak current of the semiconductor element 200 is lower than the leak current of the semiconductor element 100.

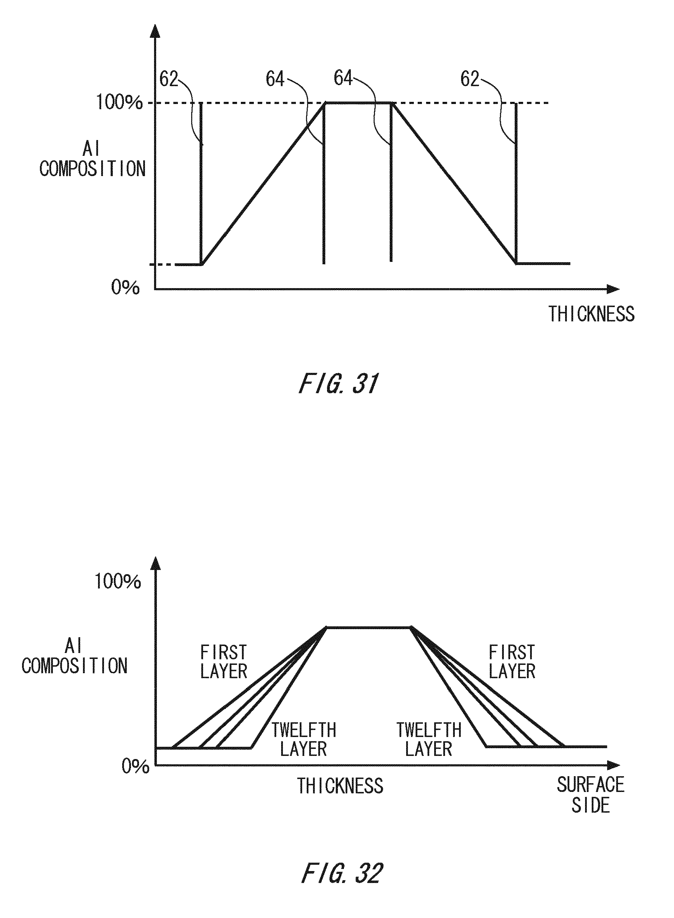

Fig. 31 shows an example of Al composition ratio change when a semiconductor layer 62 or a semiconductor layer 64 is formed at the interfaces between the second semiconductor layer 32 and layers adjacent thereto and the between the fourth semiconductor layer 34 and the layers adjacent thereto. The C doping concentration in the second semiconductor layer 32 and the fourth semiconductor layer 34 is set to 1E19 cm⁻³. The semiconductor layer 62 and the semiconductor layer 64 formed at each interface may be the same as the semiconductor layer 62 and the semiconductor layer 64 described in Figs. 29 and 30. The second semiconductor layer 32 of the present example may include a GaN layer with a thickness of approximately 0.2 nm, at the interface with the third semiconductor layer 33. The fourth semiconductor layer 34 may include a GaN layer with a thickness of approximately 0.2 nm, at the interface with the third semiconductor layer 33. The fourth semiconductor layer 34 may include an AlN layer with a thickness of approximately 0.2 nm, at the interface with the first semiconductor layer 31. In this way, warpage can be controlled and the crystallinity of the surface of the buffer region 30 can be improved to create a flat surface. When the second semiconductor layer 32 and the fourth semiconductor layer 34 are configured in this way, the leak current of the semiconductor element 200 is lower than the leak current of the semiconductor element 100.

Fig. 32 shows an example of Al composition ratio change in each of a plurality of composite layers 36 when the second semiconductor layer 32 and the fourth semiconductor layer 34 of each composite layer 36 in the buffer region 30 of the semiconductor element 200 has a different thickness. The C doping concentration in the second semiconductor layer 32 and the fourth semiconductor layer 34 is set to 1E19 cm⁻³. The composite layer 36 closest to the substrate 10 is the first layer, and the composite layer 36 farthest from the substrate 10 is the twelfth layer. In this example, the thicknesses of the second semiconductor layers 32 and the fourth semiconductor layers 34 decrease in a direction away from the substrate 10. Therefore, the Al composition ratio of the second semiconductor layers 32 and the fourth semiconductor layers 34 changes with a steep slope in a direction from the first composite layer 36 to the twelfth composite layer 36.

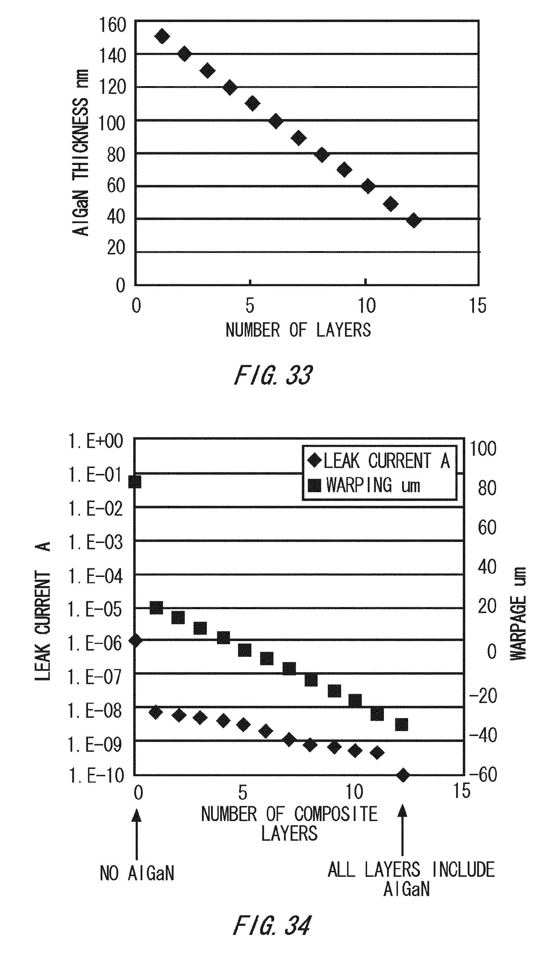

Fig. 33 shows the thicknesses of the second semiconductor layer 32 and the fourth semiconductor layer 34 in each of the composite layers 36 shown in Fig. 32. In Fig. 33, the horizontal axis represents the first to twelfth composite layers 36. The second semiconductor layers 32 and the fourth semiconductor layers 34 have thicknesses that decrease by a prescribed ratio from the first composite layer 36 to the twelfth composite layer 36. When the buffer region 30 is configured in this way, the leak current of the semiconductor element 200 is lower than the leak current of the semiconductor element 100.

Fig. 34 shows a relationship between the number of composite layers and the leak current and warpage amount in examples where the buffer region 30 has different numbers of composite layers. In these examples, the total thickness of the semiconductor element 200 is constant and there are a total of twelve composite layers. In Fig. 34, the horizontal axis indicates the number of composite layers 36 included in the AlGaN layer, i.e. the number of composite layers 36 in the buffer region 30. The C doping concentration in the second semiconductor layer 32 and the fourth semiconductor layer 34 is set to 1E19 cm⁻³. When the number of composite layers is zero, the leak current has a large value of 1E-6 A, and the warpage amount is a large positive value.

When the buffer region 30 includes one composite layer 36, the leak current is reduced to a value no greater than 1E-8 A, and the warpage amount is greatly reduced. As the number of composite layers 36 in the buffer region 30 increased, the leak current and the warpage amount gradually decrease. When there are twelve composite layers in the buffer region 30, the leak current is reduced to 1E-10 A, but the warpage amount is a large negative value. Therefore, the substrate warps significantly downward to cause a convex shape, which results in the manufacturing of the device being undesirably difficult. Accordingly, it is effective to provide at least one composite layer 36, which is formed by layering an AlN layer and a GaN layer, in combination with the buffer region 30.

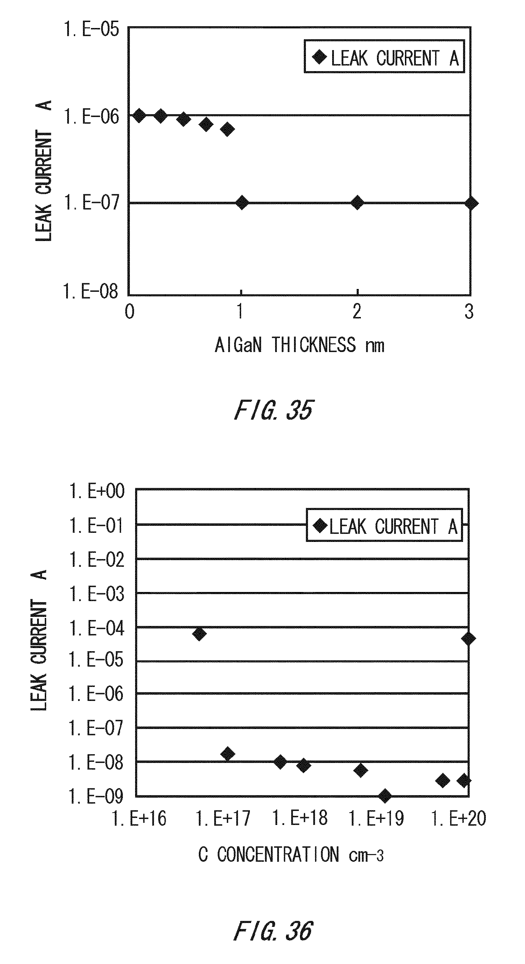

Fig. 35 shows a relationship between the thicknesses of the second semiconductor layers 32 and fourth semiconductor layers 34 in the buffer region 30 and the leak current. In Fig. 35, the horizontal axis indicates the thickness of each AlGaN layer, i.e. the thickness of one layer including a second semiconductor layer 32 and a fourth semiconductor layer 34. The C doping concentration in the second semiconductor layer 32 and the fourth semiconductor layer 34 is set to 1E19 cm⁻³. When the thickness of the second semiconductor layer 32 and the fourth semiconductor layer 34 is less than 1 nm, the leak current is approximately 1E-6 A. When the thickness of the second semiconductor layer 32 and the fourth semiconductor layer 34 is 1 nm or more, the leak current decreases to approximately 1E-7 A. Accordingly, the thickness of the second semiconductor layer 32 and the fourth semiconductor layer 34 is preferably 1 nm or more.

Fig. 36 shows a relationship between the C doping concentration in the second semiconductor layer 32 and fourth semiconductor layer 34 and the leak current. Since the C doping concentration differs according to the growth conditions, the average value of the C doping concentration is shown. For a C doping concentration range from 1E17 cm⁻³ to 9E19 cm⁻³, the leak current has a favorable value of approximately 4E-8 A or less. However, when the C doping concentration is less than 1E17 cm⁻³ or greater than or equal to 1E20 cm⁻³, the leak current becomes an undesirable value of approximately 8E-5 A. This is believed to be because an increase in the n-type carrier results in low resistance in the second semiconductor layer 32 and the fourth semiconductor layer 34. Accordingly, the C doping concentration in the second semiconductor layer 32 and the fourth semiconductor layer 34 is preferably greater than or equal to 1E17 cm⁻³ and less than 1E20 cm⁻³.

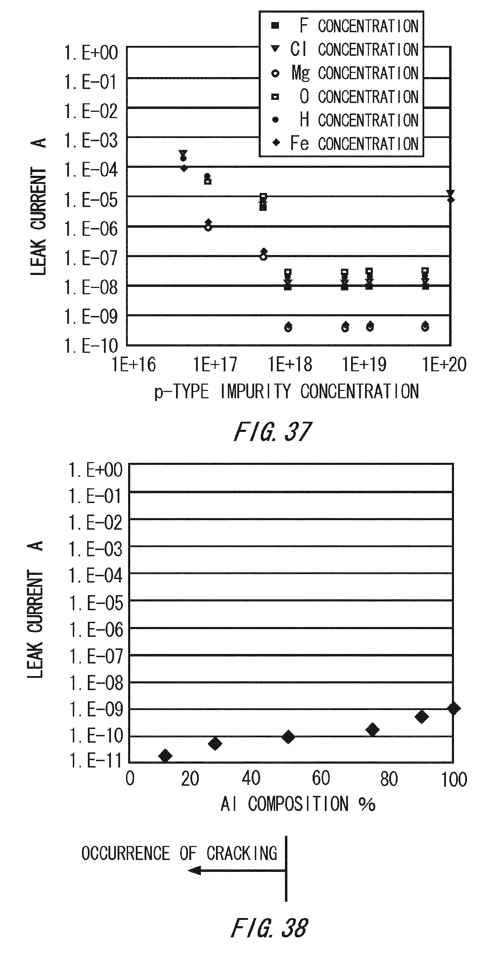

Fig. 37 shows a relationship between the leak current and the impurity doping concentration in the second semiconductor layer 32 and the fourth semiconductor layer 34, when the impurity used is fluorine, chlorine, magnesium, iron, oxygen, or hydrogen, instead of C. The C concentration was fixed at 5E16 cm⁻³, and measurement was performed. For an impurity doping concentration in a range from 1E18 cm⁻³ to 9E19 cm⁻³, the leak current has a favorable low value. However, when the impurity doping concentration is less than 1E18 cm⁻³ or greater than or equal to 1E20 cm⁻³, the leak current becomes an undesirably high value. This is believed to be because an increase in the n-type carrier results in low resistance in the second semiconductor layer 32 and the fourth semiconductor layer 34.

Fig. 38 shows a relationship between the leak current and the Al composition ratio in the third semiconductor layer 33, when the third semiconductor layer 33 is formed of AlGaN. The impurity doping concentration in the second semiconductor layer 32 and the fourth semiconductor layer 34 is set to 1E19 cm⁻³. In this case, the maximum Al composition ratio of the second semiconductor layer 32 and the fourth semiconductor layer 34 is the same as the Al composition ratio of the third semiconductor layer 33. As shown in Fig. 38, the leak current decreases according to the decrease in the Al composition ratio of the third semiconductor layer 33. However, when the Al composition ratio is 50% or less, the strain of the buffer region 30 can no longer be controlled and cracking can occur in the active layer 70. The third semiconductor layer 33 may be AlGaN with an Al composition ratio greater than 50%.

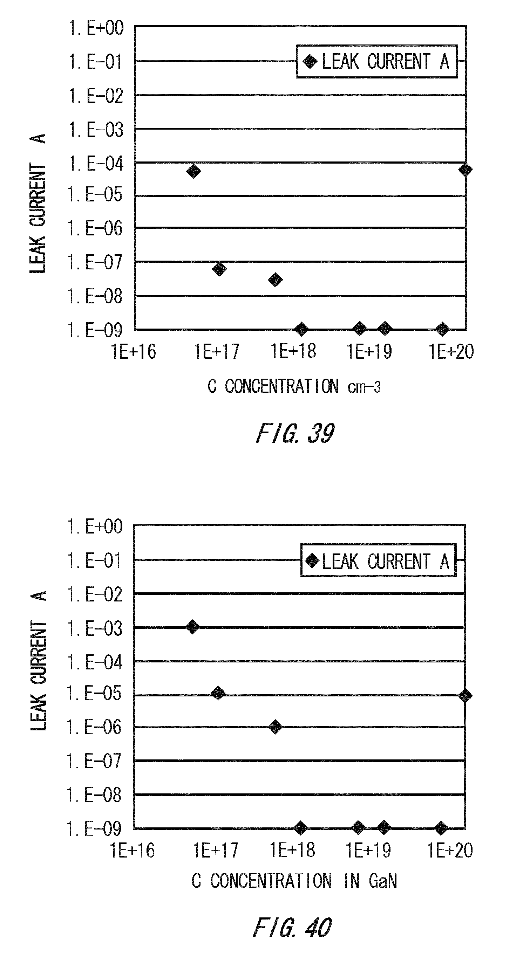

Fig. 39 shows a relationship between the leak current and the C doping concentration in the third semiconductor layer 33. If the C doping concentration is within a range from 1E17 cm⁻³ to 9E19 cm⁻³, the leak current is a favorable value of approximately 7E-8 A or less. However, if the C doping concentration is less than 1E17 cm⁻³ or greater than or equal to 1E20 cm⁻³, the third semiconductor layer 33 has a low resistance and the leak current becomes undesirably large. Accordingly, the C doping concentration in the third semiconductor layer 33 is preferably greater than or equal to 1E17 cm⁻³ and less than 1E20 cm⁻³.

Fig. 40 shows a relationship between the leak current and the C doping concentration in the first semiconductor layer 31. If the C doping concentration is within a range from 1E18 cm⁻³ to 9E19 cm⁻³, the leak current is a favorable value of approximately 1E-9 A or less. However, if the C doping concentration is less than 1E17 cm⁻³ or greater than or equal to 1E20 cm⁻³, the first semiconductor layer 31 has a low resistance and the leak current becomes undesirably large. Accordingly, the C doping concentration in the first semiconductor layer 31 is preferably greater than or equal to 1E18 cm⁻³ and less than 1E20 cm⁻³.

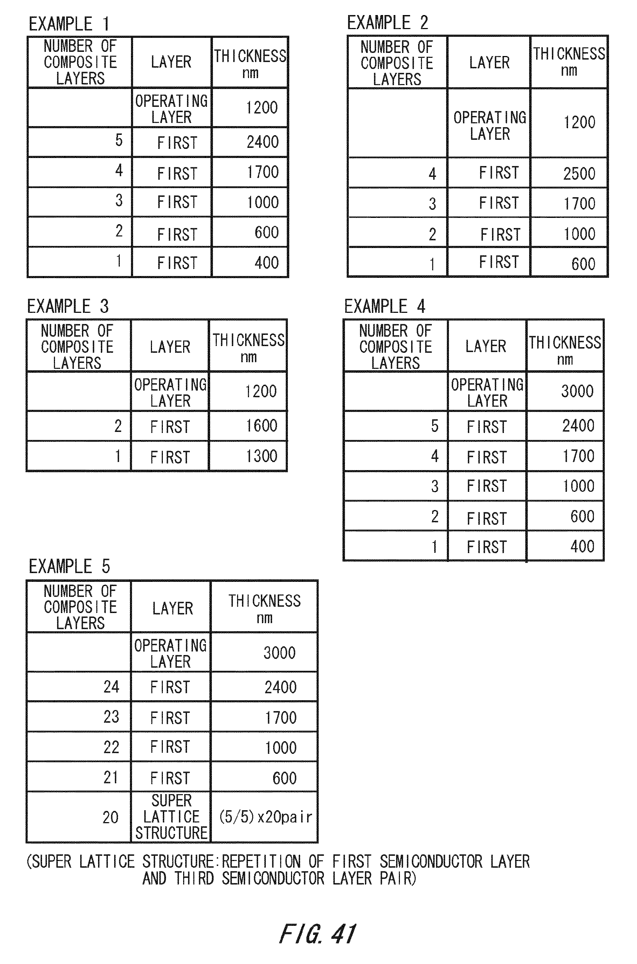

Fig. 41 shows examples 1 to 5 having different numbers of composite layers and different thicknesses of the first semiconductor layers 31 in the buffer regions 30. In each example, the number of each composite layer indicates the order of the composite layers 36 layered on the intermediate layer 20, and the thickness indicates the thickness of the first semiconductor layer 31 in each composite layer 36. In examples 1 to 5, the C doping concentration in the second semiconductor layer 32 and the fourth semiconductor layer 34 is set to 1E19 cm⁻³, and the composite layers 36 in the first semiconductor layers 31 have thicknesses that gradually increase in a direction away from the substrate 10. In example 5, a super lattice structure is formed by 20 repetitions of pairs that are each formed by a first semiconductor layer 31 with a thickness of 5 nm and a third semiconductor layer 33 with a thickness of 5 nm.

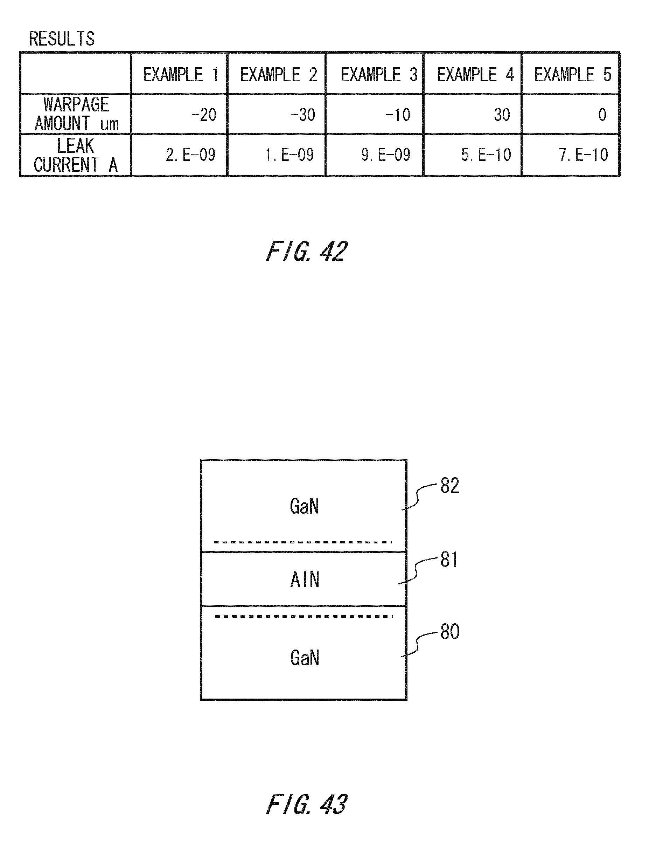

Fig. 42 shows measurement results for the leak current and warpage amount in examples 1 to 5. In each example, the leak current was reduced to a value no greater than 9E-9 A and the warpage amount was controlled to be within a range from +30 µm to -30 µm. Based on these results, it is understood that the thickness of the first semiconductor layers 31 in a buffer region 30 is preferably 400 nm or more, and that the thicknesses of the first semiconductor layers 31 in the composite layers 36 of a buffer region 30 preferably increase gradually in a direction away from the substrate.

The following describes results obtained by calculating the carrier state density distribution in a case where doping is performed in a layered body formed by sequentially layering a GaN layer, an AlN layer, and a GaN layer. The calculation was performed using a layered body of GaN/AlN/GaN as a model.

Fig. 43 shows the layered body used for the calculation. The layered body has a structure formed by sequentially layering a GaN layer 80, an AlN layer 81, and a GaN layer 82 in the stated order. As shown by the dotted line in Fig. 43, two-dimensional electron gas is generated at the hetero-interface between the GaN layer 80 and the AlN layer 81. Furthermore, two-dimensional hole gas is generated at the hetero-interface between the AlN layer 81 and the GaN layer 82.

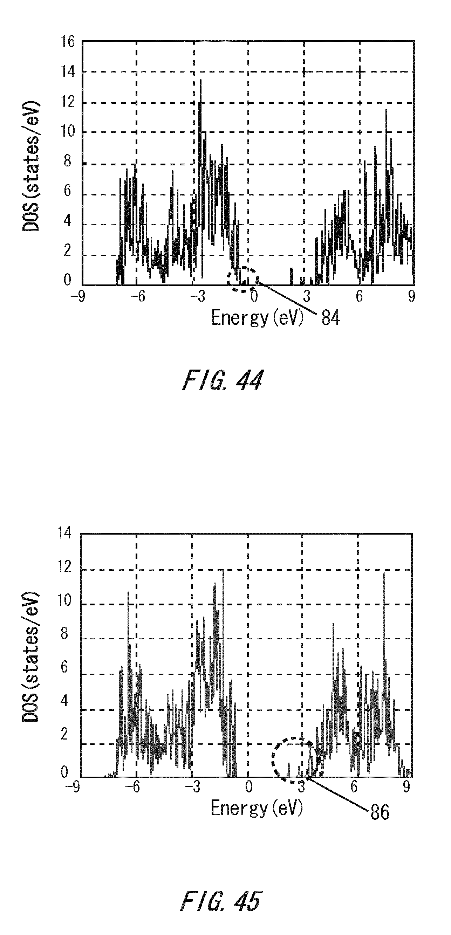

Fig. 44 shows the carrier state density distribution of the GaN layer 82 in the layered body shown in Fig. 43. A small peak is seen in the region 84 near where the potential energy is 0 eV. This peak indicates that a shallow acceptor level is formed in the region 84. This shallow acceptor level is believed to generate the two-dimensional hole gas at the hetero-interface between the GaN layer 82 and the AlN layer 81.

Fig. 45 shows the carrier state density distribution of the GaN layer 80 in the layered body shown in Fig. 43. A small peak is seen in the region 86 near where the potential energy is 3 eV. This peak indicates that a shallow donor level is formed in the region 86. This shallow donor level is believed to generate the two-dimensional electron gas at the hetero-interface between the GaN layer 80 and the AlN layer 81.

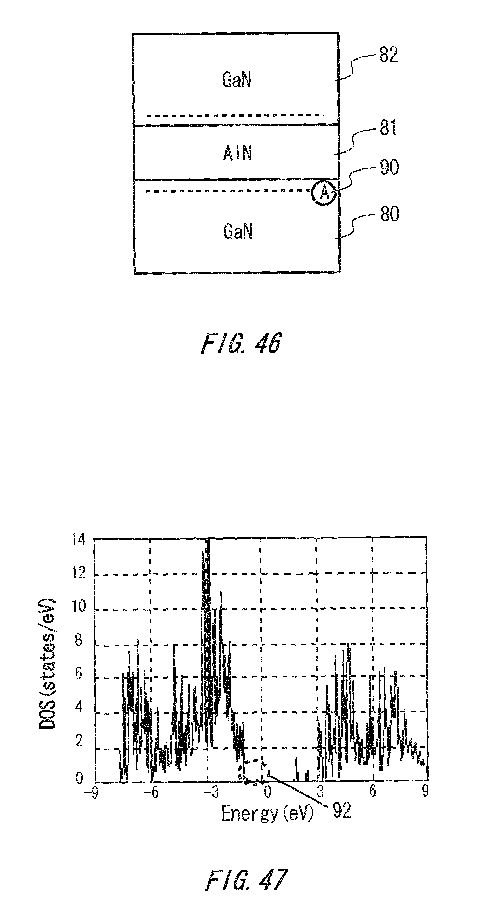

Fig. 46 shows an example in which the surface of the GaN layer 80 on the AlN layer 81 side is doped with acceptor-type impurities 90. Here, carbon C_{N} is used as the acceptor-type impurities.

Fig. 47 shows the carrier state density distribution of the GaN layer 82 in the example shown in Fig. 46. It is understood that the shallow acceptor level is eliminated in the region 92 near where the potential energy is 0 eV. This is believed to be due to the decrease in p-type carriers of the GaN layer 82 that accompanies the decrease in n-type carriers of the GaN layer 80, as a result of the GaN layer 80 being doped with the acceptor-type impurities.

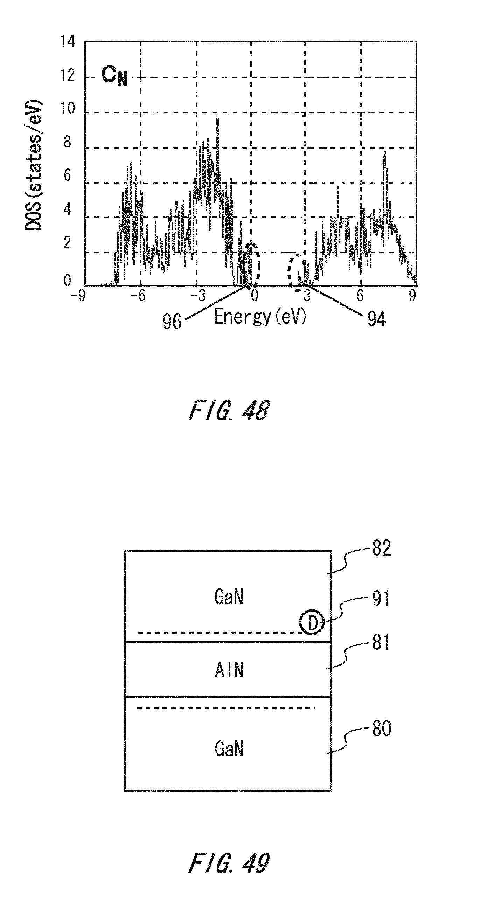

Fig. 48 shows the carrier state density distribution of the GaN layer 80 in the example shown in Fig. 46. A carbon C_{N} acceptor level is formed in the region 96 near where the potential energy is 0 eV. Furthermore, the shallow donor level remains in the region 94 near where the potential energy is 3 eV. This indicates that the two-dimensional electron gas is not completely eliminated by doping with only the acceptor-type impurities. Furthermore, the carriers are compensated by the doping with the acceptor-type impurities, and the n-type carriers are decreased overall. Therefore, it is understood that by doping the surface of the GaN layer 80 below the AlN layer 81 with the acceptor-type impurities, the n-type carriers can be reduced through the carrier compensation and the leak current can be restricted. Accordingly, in a state where an AlGaN layer is inserted between the GaN layer 80 and the AlN layer 81 to restrict the generation of two-dimensional electron gas and scatter the carriers, the n-type carriers can be further reduced through carrier compensation and the shallow donor level can be eliminated by doping with the acceptor-type impurities, thereby further decreasing the leak current.

Fig. 49 shows an example in which the surface of the GaN layer 82 on the AlN layer 81 side is doped with donor-type impurities 91. Oxygen ON may be used as the donor-type impurity.

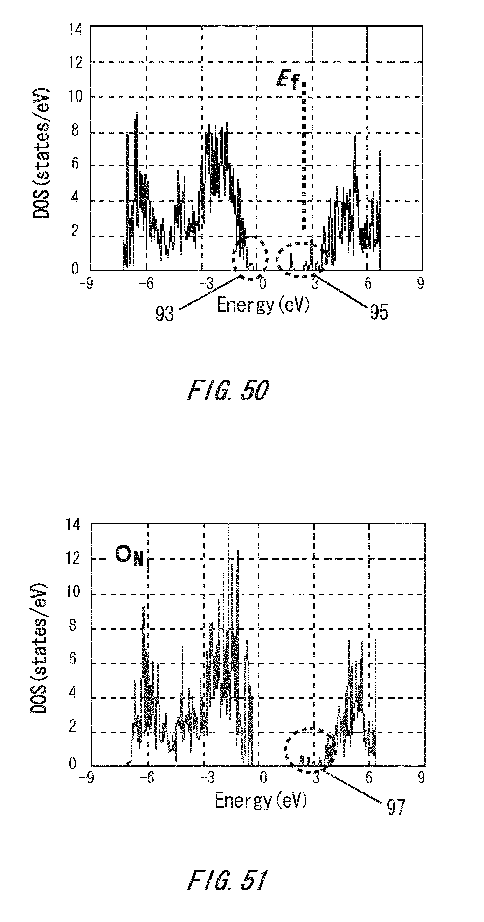

Fig. 50 shows the carrier state density of the GaN layer 82 in the example shown in Fig. 49. An oxygen ON donor level is formed in the region 95 near where the potential energy is 3 eV. Furthermore, the shallow acceptor level remains in the region 93 near where the potential energy is 0 eV. This indicates that the two-dimensional hole gas is not completely eliminated by doping with only the donor-type impurities. Furthermore, the carriers are compensated by the doping with the donor-type impurities, and the p-type carriers are decreased overall.

Fig. 51 shows the carrier state density distribution of the GaN layer 80 in the example shown in Fig. 49. A carbon shallow donor level is formed in the region 97 near where the potential energy is 3 eV. This indicates that there is remaining two-dimensional electron gas that has not been eliminated. When the donor concentration in the doped GaN layer 82 is high, carriers are supplied to the GaN layer 80, and therefore it is necessary to control the donor concentration. The n-type carriers of the GaN layer 80 are reduced by doping the GaN layer 82 with the donor-type impurities. This is because the p-type impurities are reduced through the carrier compensation of the GaN layer 82. Therefore, it is understood that by doping the surface of the GaN layer 82 above the AlN layer 81 with the donor-type impurities, the p-type carriers can be reduced through the carrier compensation and the leak current can be restricted. Accordingly, in a state where an AlGaN layer is inserted between the GaN layer 82 and the AlN layer 81 to restrict the generation of two-dimensional hole gas and scatter the carriers, the p-type carriers can be further reduced through carrier compensation and the shallow acceptor level can be eliminated by doping with the donor-type impurities, thereby further decreasing the leak current.

The thickness of the first semiconductor layer 31 may be greater than or equal to 5 nm, and the thickness of the thickest layer may be greater than or equal to 400 nm and less than or equal to 3000 nm. The warpage amount can be restricted if the thickness of the thickest first semiconductor layer 31 is greater than or equal to 400 nm, and therefore this minimum thickness is preferable. The growth time is short enough to achieve high production rates if the thickness of the thickest first semiconductor layer 31 is less than or equal to 3000 nm, and therefore this maximum thickness is preferable.

If the thicknesses of the second semiconductor layer 32 and the fourth semiconductor layer 34 are greater than or equal to 0.5 nm, the strain within the first semiconductor layer 31 can be sufficiently restricted and cracking can be prevented, and therefore this minimum thickness is preferable. If the thicknesses of the second semiconductor layer 32 and the fourth semiconductor layer 34 are less than or equal to 200 nm, the growth time is short enough to achieve high production rates, and therefore this maximum thickness is preferable.

The total thickness of the epitaxial layer formed by combining the buffer region 30 and the active layer 70 is preferably greater than or equal to 4 µm, in order to restrict the leak current and achieve sufficient withstand voltage. The film compositions of the second semiconductor layer 32 and the fourth semiconductor layer 34 need not be symmetric within a single composite layer 36, and any film composition may be used that enables control of the strain and reduction of the leak current. The total number of composite layers may be two or more, and this number can be changed according to the total thickness, warpage amount, dislocation density, or the like.

The above description used an HEMT field effect transistor as an example of the semiconductor element, but the semiconductor element is not limited to this and can instead be an insulated gate transistor (MISFET or MOSFET) or a Schottky transistor (MESFET), for example. Furthermore, by providing a cathode electrode and an anode electrode instead of the source electrode 72, the gate electrode 74, and the drain electrode 76, the configuration described above can be applied to a variety of diodes.

While the embodiments of the present invention have been described, the technical scope of the invention is not limited to the above described embodiments. It is apparent to persons skilled in the art that various alterations and improvements can be added to the above-described embodiments. It is also apparent from the scope of the claims that the embodiments added with such alterations or improvements can be included in the technical scope of the invention.

The operations, procedures, steps, and stages of each process performed by an apparatus, system, program, and method shown in the claims, embodiments, or diagrams can be performed in any order as long as the order is not indicated by "prior to," "before," or the like and as long as the output from a previous process is not used in a later process. Even if the process flow is described using phrases such as "first" or "next" in the claims, embodiments, or diagrams, it does not necessarily mean that the process must be performed in this order.

### List of Reference Numerals

10: substrate, 11, 35, 36: composite layer, 12: buffer layer, 13: Schottky electrode, 14: AlN layer, 15: GaN layer, 16: AlGaN layer, 20: intermediate layer, 30: buffer region, 31: first semiconductor region, 32: second semiconductor layer, 33: third semiconductor layer, 34: fourth semiconductor layer, 50: electron transit layer, 60: electron supply layer, 62, 64: layer, 70: active layer, 72: source electrode, 74: gate electrode, 76: drain electrode, 80: GaN layer, 81: AlN layer, 82: GaN layer, 84: region, 86: region, 90: acceptor impurity, 91: donor impurity, 92: region, 93: region, 94: region, 95: region, 96: region, 97: region, 100, 200: semiconductor element, 300: epitaxially layered body

## Claims

1. A semiconductor element comprising:
a substrate;
a buffer region that is formed over the substrate;
an active layer that is formed on the buffer region; and
at least two electrodes that are formed on the active layer, wherein
the buffer region includes a plurality of semiconductor layers having different lattice constants, and
there is a substantially constant electrostatic capacitance between a bottom surface of the substrate and a top surface of the buffer region when an electric potential that is less than an electric potential of the bottom surface of the substrate is applied to the top surface of the buffer region and a voltage between the bottom surface of the substrate and the top surface of the buffer region is changed within a range corresponding to thickness of the buffer region.

2. The semiconductor element according to Claim 1, wherein
the buffer region includes at least one composite layer, which is formed by layering a first semiconductor layer having a first lattice constant, a second semiconductor layer having a second lattice constant, and a third semiconductor layer having a third lattice constant that is different from the first lattice constant, in the stated order, and
the second lattice constant is between the first lattice constant and the third lattice constant.

3. The semiconductor element according to Claim 2, wherein
the second semiconductor layer is doped with impurities.

4. The semiconductor element according to Claim 3, wherein
a thermal expansion coefficient of the first semiconductor layer, a thermal expansion coefficient of the second semiconductor layer, and a thermal expansion coefficient of the third semiconductor layer are each greater than a thermal expansion coefficient of the substrate, and the thermal expansion coefficient of the second semiconductor layer is between the thermal expansion coefficient of the first semiconductor layer and the thermal expansion coefficient of the third semiconductor layer.

5. The semiconductor element according to Claim 3 or 4, further comprising an intermediate layer, which has a lattice constant smaller than the first lattice constant and a thermal expansion coefficient larger than the thermal expansion coefficient of the substrate, between the substrate and the buffer region.

6. The semiconductor element according to any one of Claims 3 to 5, wherein
the first semiconductor layer, the second semiconductor layer, and the third semiconductor layer include nitride-based compound semiconductors.

7. The semiconductor element according to Claim 3, wherein
the impurities include atoms that do not activate electrons.

8. The semiconductor element according to Claim 4, wherein
the impurities include at least one of carbon, fluorine, chlorine, magnesium, iron, oxygen, hydrogen, zinc, bronze, silver, gold, nickel, cobalt, vanadium, scandium, lithium, sodium, beryllium, and boron.

9. The semiconductor element according to any one of Claims 3 to 5, wherein
the first lattice constant is smaller than a lattice constant of the substrate, and the second lattice constant is smaller than the first lattice constant.

10. The semiconductor element according to any one of Claims 3 to 6, wherein
the lattice constant of the second semiconductor layer decreases in a direction from a side closer to the substrate to a side farther from the substrate.

11. The semiconductor element according to any one of Claims 3 to 7, wherein
the second semiconductor layer includes a layer that has the same composition as the third semiconductor layer and that is thinner than the third semiconductor layer, at a position distanced from the third semiconductor layer.

12. The semiconductor element according to any one of Claims 3 to 8, wherein
the second semiconductor layer includes, at least at one of an interface with the first semiconductor layer and an interface with the third semiconductor layer, a layer that has a different composition than the layer contacting the second semiconductor layer at the interface and that is thinner than the third semiconductor layer.

13. The semiconductor element according to any one of Claims 3 to 9, wherein
the first semiconductor layer includes Alₓ₁In_{y1}Ga_{1-x1-y1}N (0 ≤ x1 < 1, 0 ≤ yl ≤ 1, x1+y1 ≤ 1),
the second semiconductor layer includes Alₓ₂In_{y2}Ga_{1-x2-y2}N (0 < x2 ≤ 1, 0 ≤ y2 ≤ 1, x2+y2 ≤ 1),
the third semiconductor layer includes Alₓ₃In_{y3}Ga_{1-x3-y3}N (0 < x3 ≤ 1, 0 ≤ y3 < 1, x3+y3 ≤ 1),
x1 ≤ x2 ≤ x3, and
the second semiconductor layer has an Al ratio that increases in a direction from a side closer to the substrate to a side farther from the substrate.

14. The semiconductor element according to Claim 1, wherein
the buffer region includes at least one composite layer, which is formed by layering a first semiconductor layer having a first lattice constant, a second semiconductor layer having a second lattice constant, a third semiconductor layer having a third lattice constant that is different from the first lattice constant, and a fourth semiconductor layer having a fourth lattice constant that is between the first lattice constant and the third lattice constant, in the stated order, and
the second lattice constant is between the first lattice constant and the third lattice constant.

15. The semiconductor element according to Claim 14, wherein
at least one of the second semiconductor layer and the fourth semiconductor layer is doped with impurities.

16. The semiconductor element according to Claim 15, wherein
a thermal expansion coefficient of the first semiconductor layer, a thermal expansion coefficient of the second semiconductor layer, a thermal expansion coefficient of the third semiconductor layer, and a thermal expansion coefficient of the fourth semiconductor layer are each greater than a thermal expansion coefficient of the substrate, and the thermal expansion coefficient of the second semiconductor layer and the thermal expansion coefficient of the fourth semiconductor layer are each between the thermal expansion coefficient of the first semiconductor layer and the thermal expansion coefficient of the third semiconductor layer.

17. The semiconductor element according to Claim 15 or 16, further comprising an intermediate layer, which has a lattice constant smaller than the first lattice constant and a thermal expansion coefficient larger than the thermal expansion coefficient of the substrate, between the substrate and the buffer region.

18. The semiconductor element according to any one of Claims 15 to 17, wherein
the first semiconductor layer, the second semiconductor layer, the third semiconductor layer, and the fourth semiconductor layer include nitride compound semiconductors.

19. The semiconductor element according to Claim 15, wherein
the impurities include atoms that do not activate electrons.

20. The semiconductor element according to Claim 19, wherein
the impurities include at least one of carbon, fluorine, chlorine, magnesium, iron, oxygen, hydrogen, zinc, bronze, silver, gold, nickel, cobalt, vanadium, scandium, lithium, sodium, beryllium, and boron.

21. The semiconductor element according to any one of Claims 15 to 20, wherein
the impurities include atoms that do not activate holes.

22. The semiconductor element according to Claim 21, wherein
the impurities include at least one of silicon, oxygen, germanium, phosphorous, arsenic, and antimony.

23. The semiconductor element according to any one of Claims 15 to 22, wherein
the first lattice constant is smaller than a lattice constant of the substrate, and the second lattice constant is smaller than the first lattice constant.

24. The semiconductor element according to any one of Claims 15 to 23, wherein
the lattice constant of the second semiconductor layer decreases in a direction from a side closer to the substrate to a side farther from the substrate, and the lattice constant of the fourth semiconductor layer increases in a direction from a side closer to the substrate to a side farther from the substrate.

25. The semiconductor element according to any one of Claims 15 to 24, wherein
the second semiconductor layer includes a layer that has the same composition as the third semiconductor layer and that is thinner than the third semiconductor layer, at a position distanced from the third semiconductor layer.

26. The semiconductor element according to any one of Claims 15 to 25, wherein
the second semiconductor layer includes, at least at one of an interface with the first semiconductor layer and an interface with the third semiconductor layer, a layer that has a different composition than the layer contacting the second semiconductor layer at the interface and that is thinner than the third semiconductor layer.

27. The semiconductor element according to any one of Claims 15 to 26, wherein
the fourth semiconductor layer includes a layer that has the same composition as the third semiconductor layer and that is thinner than the third semiconductor layer, at a position distanced from the third semiconductor layer.

28. The semiconductor element according to any one of Claims 15 to 27, wherein
the fourth semiconductor layer includes, at least at one of an interface with the first semiconductor layer and an interface with the third semiconductor layer, a layer that has a different composition than the layer contacting the fourth semiconductor layer at the interface and that is thinner than the third semiconductor layer.

29. The semiconductor element according to any one of Claims 15 to 28, wherein
the first semiconductor layer includes Alₓ₁In_{y1}Ga_{1-x1-y1}N (0 ≤ x1 < 1, 0 ≤ yl < 1, x1+y1 ≤ 1),
the second semiconductor layer includes Alₓ₂In_{y2}Ga_{1-x2-y2}N (0 < x2 ≤ 1, 0 ≤ y2 ≤ 1, x2+y2 ≤ 1),
the third semiconductor layer includes Alₓ₃In_{y3}Ga_{1-x3-y3}N (0 < x3 ≤ 1, 0 ≤ y3 < 1, x3+y3 ≤ 1),
the fourth semiconductor layer includes Alₓ₄In_{y4}Ga_{1-x4-y4}N (0 < x4 ≤ 1, 0 ≤ y4 ≤ 1, x4+y4 ≤ 1),
x1 ≤ x2 and x4 ≤ x3,
the second semiconductor layer has an Al ratio that increases in a direction from a side closer to the substrate to a side farther from the substrate, and
the fourth semiconductor layer has an Al ratio that decreases in a direction from a side closer to the substrate to a side farther from the substrate.

30. The semiconductor element according to any one of Claims 15 to 29, wherein
the second semiconductor layer and the fourth semiconductor layer have a different thickness in each composite layer.

31. The semiconductor element according to any one of Claims 15 to 30, wherein
the second semiconductor layer and the fourth semiconductor layer each have a thickness greater than or equal to 1 nm.

32. A semiconductor element manufacturing method comprising:
preparing a substrate;
forming a buffer region above the substrate;
forming an active layer on the buffer region; and
forming at least two electrodes on the active layer, wherein
the forming the buffer region includes performing, at least once, a cycle that includes forming a first semiconductor layer with a first lattice constant, forming a second semiconductor layer with a second lattice constant, and forming a third semiconductor layer with a third lattice constant that is different from the first lattice constant, in the stated order,
the second lattice constant is between the first lattice constant and the third lattice constant, and
the forming the second semiconductor layer includes doping with impurities.

33. The manufacturing method according to Claim 32, wherein
the impurities include atoms that do not activate electrons.

34. The manufacturing method according to Claim 33, wherein
the impurities include at least one of carbon, fluorine, chlorine, magnesium, iron, oxygen, hydrogen, zinc, bronze, silver, gold, nickel, cobalt, vanadium, scandium, lithium, sodium, beryllium, and boron.

35. A semiconductor element manufacturing method comprising:
preparing a substrate;
forming a buffer region above the substrate;
forming an active layer on the buffer region; and
forming at least two electrodes on the active layer, wherein
the forming the buffer region includes performing, at least once, a cycle that includes forming a first semiconductor layer with a first lattice constant, forming a second semiconductor layer with a second lattice constant, forming a third semiconductor layer with a third lattice constant that is different from the first lattice constant, and forming a fourth semiconductor layer with a lattice constant that is between the first lattice constant and the third lattice constant, in the stated order,
the second lattice constant is between the first lattice constant and the third lattice constant, and
at least one of the forming the second semiconductor layer and the forming the fourth semiconductor layer includes doping with impurities.

36. The manufacturing method according to Claim 35, wherein
the impurities include atoms that do not activate electrons.

37. The manufacturing method according to Claim 36, wherein
the impurities include at least one of carbon, fluorine, chlorine, magnesium, iron, oxygen, hydrogen, zinc, bronze, silver, gold, nickel, cobalt, vanadium, scandium, lithium, sodium, beryllium, and boron.

38. The manufacturing method according to any one of Claims 35 to 37, wherein
the impurities include atoms that do not activate holes.

39. The manufacturing method according to Claim 38, wherein
the impurities include at least one of silicon, oxygen, germanium, phosphorous, arsenic, and antimony.
